(19) Europäisches Patentamt
European Patent Office
Office européen des brevets

(11) **EP 2 455 945 B1**

(12) **EUROPEAN PATENT SPECIFICATION**

(45) Date of publication and mention
of the grant of the patent:
**04.09.2013 Bulletin 2013/36**

(51) Int Cl.:
*G21C 21/02* (2006.01)     *G21C 3/62* (2006.01)
*C23C 16/44* (2006.01)     *C23C 16/442* (2006.01)

(21) Application number: **12156006.4**

(22) Date of filing: **20.04.2005**

(54) **Apparatus for manufacturing coated fuel particles for high-temperature gas-cooled reactor**

Vorrichtung zur Herstellung beschichteter Brennstoffpartikel für einen gasgekühlten Hochtemperaturreaktor

Appareil de fabrication de particules de combustible enrobées pour un réacteur à haute température refroidi au gaz

(84) Designated Contracting States:
**FR**

(30) Priority: **05.11.2004 JP 2004321968**
**19.11.2004 JP 2004335369**
**21.04.2004 JP 2004125286**
**02.08.2004 JP 2004225507**
**25.08.2004 JP 2004244804**

(43) Date of publication of application:
**23.05.2012 Bulletin 2012/21**

(62) Document number(s) of the earlier application(s) in
accordance with Art. 76 EPC:
**05734488.9 / 1 752 991**

(73) Proprietor: **Nuclear Fuel Industries, Ltd.**
**Tokyo 105-0001 (JP)**

(72) Inventors:
• **Okubo, Kazutoshi**
**Ibaraki 319-1196 (JP)**
• **Honda, Masaki**
**Ibaraki 319-1196 (JP)**
• **Yasuda, Atsushi**
**Ibaraki 319-1196 (JP)**
• **Takayama, Tomoo**
**Ibaraki 319-1196 (JP)**

(74) Representative: **Regimbeau**
**20, rue de Chazelles**
**75847 Paris Cedex 17 (FR)**

(56) References cited:
**GB-A- 1 564 361**     **JP-A- 5 287 285**
**JP-A- 2004 286 719**     **US-A- 3 398 718**

**Description**

Technical Field

The present invention relates to an apparatus for manufacturing coated fuel particles used in high-temperature gas-cooled reactors (HTGRs). More specifically, the present invention relates to an apparatus for manufacturing coated fuel particles for the HTGRs, the apparatus being equipped with a fluidized-bed reaction apparatus wherein coated fuel particles are produced by forming a multilayered coating on fuel kernels consisting of uranium compounds such as uranium dioxide.

Background Art

The HTGRs can deliver helium gas at a high outlet temperature with a high degree of intrinsic safety by constructing the reactor core including the fuel arrangement with graphite members having a large thermal capacity and allowing soundness to be maintained at a high temperature, and also by using a gas coolant, such as helium, which does not cause chemical reaction even at a high temperature. The obtained high temperature heat of about 900°C makes heat utilization in a wide range of fields possible, not only in the field of electric power generation but also in the fields of hydrogen production, chemical plants, and others.

As fuel for the HTGRs, generally used are fuel kernels about 350 to 650 micrometers in diameter produced by using compounds including uranium such as uranium oxide as the starting material and sintering the compounds in the form of ceramics. More specifically, as fuel for the HTGRs, used are coated fuel particles being produced by forming a multiple coating layer on the outer surfaces of fuel kernels and having the fuel kernels in the centre of the coated fuel particles.

As such coated fuel particles, generally used are the particles having a multilayered coating of a fourfold layer in total around the fuel kernels. More specifically, a low-density pyrolytic carbon layer having a density of about 1 $g/cm^3$ is formed as a first coating layer, a high-density pyrolytic carbon layer having a density of about 1.8 $g/cm^3$ is formed as a second coating layer, a silicon carbide (SiC) layer having a density of about 3.2 $g/cm^3$ is formed as a third coating layer, and further a high-density pyrolytic carbon layer having a density of about 1.8 $g/cm^3$ is formed as a fourth coating layer in the similar manner as the second coating layer.

The first coating layer has both the function as a gas reservoir of gaseous fission products (FP) and the function as a buffer to absorb the deformation of fuel kernels. Further, the second coating layer has the function of retaining gaseous fission products, and the third coating layer has the function of retaining solid fission products and also is a main strengthening member of the coating layers. The fourth coating layer has the function of retaining gaseous fission products like that of the second coating layer and also the function as the protective layer of the third coating layer.

Such coated fuel particles as stated above generally have diameters of about 500 to 1,000 micrometers. The coated fuel particles are dispersed in a graphite base material and moulded into a prescribed shape called fuel compacts, and further formed into a shape of a fuel rod by putting a prescribed amount of the fuel compacts into a cylinder made of graphite and plugging the top and bottom of the cylinder. The fuel rods are finally inserted into plural insertion openings of a hexagonal-column-shaped graphite block, a plurality of hexagonal-column-shaped graphite blocks are piled to form honeycomb arrangement of multiple stages, and thus a reactor core is formed.

Fuel kernels before coated from which coated fuel particles are produced are generally manufactured through the following processes. That is, firstly uranyl nitrate stock solution is produced by dissolving powder of uranium oxide in nitric acid, and then stock solution for dripping is produced by adding pure water and an additive to the uranyl nitrate stock solution and stirring them. The additive is a thickening agent added so that the droplets of dripping uranyl nitrate may form a spherical shape by the own surface tension during fall and at the same time so that the stock solution may be gelled through contact with ammonia and, for example, polyvinyl alcohol resin, resin having the nature of gelling under an alkaline condition, polyethylene glycol, metolose (Trade name), and others are nominated as the additive.

The stock solution for dripping prepared as stated above is cooled to a prescribed temperature and thus the viscosity thereof is adjusted. Thereafter, the stock solution is dripped into an ammonia aqueous solution by vibrating dripping nozzles of a small diameter. The droplets are exposed to an ammonia gas in the space during the time until the droplets land on the surface of the ammonia aqueous solution to gel the surfaces thereof and thereby the droplets are prevented from deforming at the landing. The stock solution which has entered as droplets into the ammonia aqueous solution is gelled by the aforementioned additive at the same time as the uranyl nitrate sufficiently reacts with the ammonia and takes the form of gelatinous particles containing ammonium diuranate (ADU). The obtained ADU gelatinous particles are dried and baked in the air to remove the water and the additive therein, thus take the form of uranium trioxide particles, further are reduced and sintered and thereby take the form of spherical fuel kernels composed of ceramics uranium dioxide of a high-density.

Coated fuel particles using such fuel kernels are produced with a reaction apparatus equipped with a fluidized bed. As an example thereof, quoted is a method of forming coating layers by charging fuel kernels in a fluidized-bed reaction vessel, ejecting a coating material mixed gas from a gas inlet nozzle disposed at the bottom of the reaction vessel through a gas inlet pipe and thus fluidizing the fuel kernels, and depositing the coating material molecules on the surfaces of the fuel kernels by the thermal decomposition of the coating material mixed gas during the fluidization (cf. JP-A-5273374).

For example, the aforementioned first coating layer of a low-density carbon is formed by pyrolytically decomposing acetylene ($C_2H_2$) at about 1,400°C, and the second or fourth coating layer of a high-density pyrolytic carbon is formed by pyrolytically decomposing propylene ($C_3H_6$) at about 1,400°C. In the case of the third coating layer, an SiC layer is formed by pyrolytically decomposing methyltrichlorosilane ($CH_3SiCl_3$) at about 1,600°C.

When such coating layers are formed with the aforementioned respective coating materials, a coating gas containing one of the coating materials is mixed with another gas to form a coating material mixed gas corresponding to each of the coating layers to be formed, and the process is carried out in the state where the particles are sufficiently fluidized in the reaction vessel in order to uniformly apply the coating layers to the particles. This is the reason why the reaction apparatus for manufacturing coated fuel particles is called a fluidized-bed. As the gas to be mixed for fluidizing particles (namely fluidizing gas), generally used is argon gas, which is one of the inert gases, in the cases of forming the first, second, and fourth coating layers, and hydrogen gas or a hydrogen-argon mixed gas in the case of forming the third coating layer.

Further, general fuel compacts are obtained by further coating the surfaces of coated fuel particles with a graphite matrix material composed of graphite powder, phenolic resin and others, then press-forming or mould-forming the product into a hollow or solid-core cylindrical shape, thereafter subjecting the compacts to heat treatment in order to carbonize the phenolic resin contained as a binder in the compacts, and further subjecting the compacts to another heat treatment in order to remove gas components contained in the compacts.

In the case of a conventional apparatus for manufacturing coated fuel particles for the HTGRs, the top lid of an airtight housing (chamber) is mounted in an openable and closable manner (cf. JP-A-5287285), and hence the interior of a fluidized-bed reaction vessel can be accessed only from the top of the airtight housing.

Further, the conventional apparatus for manufacturing coated fuel particles for the HTGRs is equipped with a fluidized-bed reaction vessel to be charged with uranium dioxide fuel kernels through the top of the housing surrounding the vessel, into which vessel a mixed gas of a coating gas and a fluidizing gas is introduced from an inlet through a gas inlet nozzle mounted on the bottom of the vessel to fluidize the kernels and to apply coating on the surfaces thereof. Inside the housing, a graphite-made heater is disposed around the outer periphery of the reaction vessel to heat the interior of the vessel, and an insulating member made of graphite likewise is disposed around the yet outer periphery of the heater. Here, as the heater, any heater may be adopted as long as it is disposed around the outer periphery of the reaction vessel and, for example, a heater of a cylindrical shape or a plurality of bar heaters evenly arranged around the outer periphery of the fluidized-bed reaction vessel may also be adopted.

Further, in the conventional apparatus for manufacturing coated fuel particles for the HTGRs, a gas feed system for supplying a coating gas and a fluidizing gas to the fluidized-bed reaction vessel is designed so that the coating gas and the fluidizing gas to be supplied to the reaction vessel may independently be controlled with shut-off valves and flow regulators. For example, a fluidizing gas and a coating gas are supplied from their respective bottles and then mixed with each other to form a coating material mixed gas to be used in each of the forming processes of the first, second, and fourth coating layers. In contrast with this, in the process for forming the third coating layer, a coating material mixed gas is produced from an evaporation tank in which methyltrichlorosilane in liquid phase evaporates at an elevated temperature, and the resultant evaporated methyltrichlorosilane is mixed with and spouted out from the tank by a carrier gas (hydrogen) which is introduced into the tank from a liquefied hydrogen gas bottle and functions as a part of the fluidizing gas when it is supplied into the vessel. The gas feed system supplies these coating material mixed gases into the fluidized-bed reaction vessel for their respective coating processes. Further, the exhaust gas from the fluidized-bed reaction vessel is transferred to incidental waste gas treatment equipments of the gas feed system.

That is, the liquid methyltrichlorosilane contained in the evaporation tank is maintained at an elevated temperature and hydrogen gas is introduced into the evaporation tank, and thus evaporated methyltrichlorosilane is mixed with the hydrogen gas and fed into the reaction vessel through the use of the hydrogen gas as a carrier gas. Preferably in this case, the gas feed system includes an equipment, called a gas collecting pipe, disposed in the feed line between the tank and the vessel, for properly mixing thus evaporated methyltrichlorosilane with high flow rate hydrogen gas for the purpose of fluidizing fuel kernels within the reaction vessel.

Document US 3 398 718 discloses a gas-solid coating apparatus comprising: a contacting chamber adapted to hold a columnar bed of discrete solid particles; said chamber having a major portion comprising an upper cylindrical section and a tapered lower section; a downwardly directed substantially conical face plate having an included angle between 100 to 150; said face plate being apertured at its apex and having a plurality of apertures peripherally disposed thereabout; said face plate being joined at the periphery thereof to said tapered lower section, thereby forming a bottom for said contacting chamber; a terminal member including an upper plate portion closely spaced from and conically generally conforming to said face plate means connecting and enclosing the face plate and upper plate portion at the peripheral extents thereof whereby is formed a second chamber, said second chamber communicating with said contacting chamber through said peripherally disposed apertures; said upper plate portion comprising the upper wall of an annular chamber including fluid inlet and outlet means and being in a heat transfer relationship with said second chamber; a central gas passageway connected with the face plate at the centrally disposed aperture in said face plate and passing centrally through said annular chamber whereby is provided a gas-inlet and solids outlet for the contacting chamber; a conduit disposed concentrically about said central gas passageway and connected to the bottom wall of said annular chamber at a central aperture thereof whereby to communicate with the contacting chamber through said peripherally disposed apertures; gas feed means communicating separately with said gas passageway and said conduit whereby to maintain as a fluidized bed, and to coat, solids contained in the contacting chamber; means to supply coolant to said annular chamber; and means to heat said contacting chamber.

Besides, document JP 5 287285 discloses a fluidized bed apparatus in which coated solid particles are obtained by introducing solid particles together with fluidizing gas into a reactor accommodated in a chamber to fluidize the particles and then introducing reaction gas into the reactor to form a coating layer of the reaction gas component on the outer surface of the solid particles, and in which a vibration transfer member is mounted in such a way that one end thereof is in contact with the outer wall of the reactor and the other end projects outside the chamber to grasp the fluidizing condition of the solid particles in the reactor, that is not accessible due to high temperature, from the outside of the chamber.

Disclosure of the invention

Problem to be solved by the Invention

There are several problems to be solved in response to upsizing of such a fluidized-bed reaction apparatus for manufacturing coated fuel particles for the HTGRs. The first problem is how to design a gas inlet nozzle by which makes it possible to stably supply a coating material mixed gas into a fluidized-bed reaction vessel in response to upsizing of the apparatus. That is, in a conventional reaction apparatus, a gas inlet nozzle called a single nozzle is generally used. A coating material mixed gas enters the gas inlet nozzle from a single gas inlet pipe and is introduced into a reaction vessel through a single nozzle opening. Hence the flow of the incoming coating material mixed gas has weakened towards the outside and uniform fluidization of fuel kernels in the fluidized-bed reaction vessel has hardly been obtained.

In particular, in the case of forming an SiC layer as the aforementioned third coating layer, sediment of SiC builds up gradually at a nozzle opening, hence the sediment increases as the coating reaction time lengthens, the nozzle opening is clogged, thus long time coating reaction cannot be secured, and resultantly it has been difficult to form the third coating layer or SiC layer having a thickness of 25 micrometers or more.

This kind of problem is particularly serious when the throughput at one lime (one batch amount) is increased in order to improve production efficiency, namely when the diameter of a fluidized-bed reaction vessel in which particles are charged is enlarged in order to increase a batch amount. As the diameter of a reaction vessel increases, the amount of particles, which are hardly fluidized or not fluidized in the inner peripheral region inside the reaction vessel, increases with a single nozzle and it becomes more difficult to uniformly coat fuel kernels in a batch.

As one countermeasure for solving this kind of problem for example, it may be possible to branch a single gas inlet channel of the nozzle into a plurality of channels so that a coating material mixed gas is injected into a fluidized-bed reaction vessel through a plurality of nozzle openings of the nozzle mounted on the bottom of the reaction vessel. In this case, however, it is difficult to realize a more uniform gas supply unless the conditions including the positions and sizes of the nozzle openings, gas injection angles determined by the angles of gradient of the respective gas inlet channels are properly set.

In view of the above situation, the first object of the present invention is to provide a fluidized-bed reaction apparatus comprising a gas inlet nozzle which allows a coating material mixed gas to be more stably and uniformly supplied than ever into a reaction vessel and further allows high-quality coated fuel particles to be produced even when the dimensions of a reaction vessel are enlarged.

The second problem is how to improve the maintainability of a fluidized-bed reaction apparatus. That is, in a conventional fluidized-bed reaction apparatus for manufacturing coated fuel particles for HTGRs, only the top portion of an airtight housing has been openable and closable. As a result, the attachment and detachment of a fluidized-bed reaction vessel to and from the airtight housing of the apparatus and the cleaning of the interior of the fluidized-bed reaction vessel have been carried out through the top lid of the airtight housing and thereby the handling of the fluidized-bed reaction vessel has been cumbersome and the maintainability thereof has been very poor.

Further, the aforementioned first to fourth coating layers are successively formed in a fluidized-bed reaction vessel and the number of particles, which can be processed at a batch time, is limited. Hence, when a large amount of coated fuel particles are to be manufactured, the successive coating processes are carried out repeatedly. On the contrary, in order to keep the high quality of coated fuel particles, all maintenance work including the change of the reaction vessel, the cleaning of the interior of the reaction vessel, the recovery of soot and SiC adhering to the interior of feed pipes and others is required every time when each reaction process in the successive coating processes is started.

However, since such a reaction vessel has a lengthy pipe shape so as to secure a height of a fluidized bed space necessary for fluidizing fuel kernels in the interior, the operability of all maintenance work including the change of the reaction vessel, the cleaning of the interior of the reaction vessel and others is very poor, a whale of a time and effort are required before the start of the next coating process, and those cause the efficiency of the entire manufacturing process of coated fuel particles to deteriorate. The aforementioned problem of maintenance is particularly serious when an apparatus, namely a reaction vessel, is upsized.

In view of the above situation, the second object of the present invention, in addition to the first object, is to make it possible to be excellent in the operability of maintenance work including the change, such as the attachment and the detachment, of a reaction vessel, the cleaning of the interior of the vessel and the like, and to improve the efficiency of the entire manufacturing process even when a fluidized-bed reaction vessel is upsized.

The third problem is how to prevent the thermal capability and the thermal insulating properties of the apparatus from being deteriorated. That is, in a conventional reaction apparatus equipped with a fluidized-bed reaction vessel, coated fuel particles obtained by forming coating layers on fuel kernels are taken out through an inlet port disposed beneath the reaction apparatus for introducing a coating material mixed gas. To discharge the coated fuel particles through the inlet port, it is necessary to remove downward the gas inlet nozzle mounted on the bottom of the reaction vessel. Consequently, it is common practice not to permanently secure the gas inlet nozzle to the reaction vessel bottom.

As a result, a coating material mixed gas leak out from a clearance gap between the gas inlet nozzle and the reaction vessel, and pervade the periphery of a heater and an insulating member both disposed within the same airtight housing of the vessel. The pervading gas does not cause problems when the aforementioned first, second, and fourth coating layers are formed. When the third coating layer is formed, however, if hydrogen gas, which is contained in a coating material mixed gas as a carrier or fluidizing gas, leaks out from the gap, since the interior of the housing is heated to about 1,600°C, graphite which is a typical constituent material of the heater and the insulating member reacts with thus leaked hydrogen and hydrocarbon is generated.

Since the generation of hydrocarbon means that the amount of the graphite which constitutes the heater and the insulating member decreases and the wear and damage thereof are caused, with the result that the electric resistivity of the heater and thus the amount of heat generation may be changed. Also, in the case of the insulating member is damaged, heat tends to be dissipated from the portions of the wear and damage of the graphite and the thermal insulating properties may be deteriorated.

As a result, the distribution of coating temperature in a reactor vessel, which largely affects the properties of the coating layers, changes. As a consequence, in the case of carrying out successive processes repeatedly, since the reaction conditions undesirably vary for every batch, there arises a serious problem in that the quality of the coating layers, which is very important for the function of confining the fissionable materials in fuel for HTGRs, becomes unhomogeneous. The problem worsens as the dimensions of the reaction apparatus are enlarged.

The third object of the present invention, in addition to the first object, is to provide a fluidized-bed reaction apparatus being capable of stabilizing the temperature distribution in a reaction vessel, which largely affects the properties of coating layers, even in the case of consecutive manufacturing process. The apparatus is to be not largely affected by the upsizing thereof, and is to be suitable for the consecutive production of the coated fuel particles.

The fourth problem relates to a gas feed system for supplying a coating material mixed gas to be used for forming an SIC layer into the reaction vessel. That is, a coating material mixed gas produced by mixing a carrier or fluidizing gas and a gas of silicon carbide compounds as the silicon carbide source (in most cases, mixture of $H_2$ carrier gas and methyltrichlorosilane evaporated gas) is used in the case of forming an SiC layer or the aforementioned third coating layer, and the ratio of the silicon carbide components in an SiC coating material mixed gas generated in an evaporation tank depends on the temperature of the evaporation tank and the amount or flow rate of the $H_2$ carrier gas. Hence, when the amount of the generated methyltrichlorosilane evaporated gas is unstable, there has been the possibility that the thickness and the density of thus formed SiC layer are affected and the non-uniformity of the same is caused.

Further, the temperature of the SiC coating material mixed gas generated in the evaporation tank at an elevated temperature may be lowered by the mixing with a fluidizing gas and the transportation in a gas feed line pipe. In particular, the gas feed line pipe usually includes flections toward vertically and horizontally and the specific gravity of the methyltrichlorosilane is larger than that of hydrogen gas. Therefore, there has been a problem in that the methyltrichlorosilane stays at a location where the pipe is deflected or at a lower part of the pipe at which hydrogen gas flows upward, that the pressure of supply gas is not stabilized by the influence of the pressure loss in the gas feed line pipe, and that the methyltrichlorosilane can not stably be supplied into a reaction vessel. As a result, there has been the possibility that the thickness and the density of the SiC layer are affected and the instability of the same is caused.

The problem becomes more serious when an apparatus is upsized. That is, it is necessary to increase the amount of supplied gas with the upsizing of an apparatus. As a result, it becomes difficult to equalize the temperature distribution with the upsizing of the evaporation tank and the instability of the ratio of the components in the SiC coating material mixed gas is caused. Further, by the increase of the diameter of a gas feed line pipe, the temperature distribution in the pipe becomes uneven and the ratio of the components in the SiC coating material mixed gas becomes unstable.

The fourth object of the present invention, in addition to the first object, is to obtain a manufacturing apparatus which makes it particularly possible to stably supply the SiC coating material mixed gas into a reaction vessel, The manufacturing apparatus must have no influence on the thickness and the density of the SiC layer, and is to be adapted to obtain a uniform SiC layer even when the apparatus is upsized.

Means for Solving The Problem

Accordingly, the present invention provides an apparatus for manufacturing coated fuel particles for a HTGR, according to claim 1 or 2.

Consequently, it is possible to adjust the inflow of a coating material mixed gas with the plural nozzle openings disposed on the nozzle body at positions allocated along the concentric circular zones to uniformly fluidize fuel kernels and to manufacture coated fuel particles of high quality even when a fluidized-bed reaction vessel is upsized.

That is, with this nozzle, it is possible to supply a coating material mixed gas into a reaction vessel entirely uniformly in comparison with a conventional gas inlet nozzle having a single horn-shaped gas inlet channel, and hence it is possible to equalize not only the fluidization of fuel kernels but also the formed coating layer and obtain coated fuel particles of sufficient and uniform quality.

Further, in the process of forming the aforementioned third coating layer composed of an SiC layer, since the supply of a coating material mixed gas is dispersed with the nozzle openings, generated SiC sediment also is dispersed to the nozzle openings, the sediment at the nozzle openings does not so grow as to clog the openings, and the danger of hindering the supply of the coating material mixed gas is also avoided. As a consequence, it is possible to maintain the SiC coating reaction for a long period of time, thereby forming an SiC layer having a heavy thickness of 25 micrometers or more for example, which has heretofore been difficult to obtain.

In the context of the present invention, the number of gas inlet channels through which a coating material mixed gas is supplied to the nozzle openings may be one or more. For example, it may be adopted that a single gas inlet channel is branched into a plurality of sub channels on the way to the interior of a reaction vessel and a coating material mixed gas is supplied to a plurality of nozzle openings. Also, there may be a plurality of groups in each of which a single gas inlet channel is branched into a plurality of sub channels on the way to the interior of a reaction vessel and a coating material mixed gas is supplied to the plural nozzle openings. Further, even the case where a coating material mixed gas is supplied from a plurality of gas inlet channels to a corresponding plurality of nozzle openings may also be adopted.

Consequently, as the nozzle openings of the gas inlet channel or channels according to the present invention, adopted may be any of the cases where all of the nozzle openings communicate through a single gas inlet channel, or each of the nozzle openings communicates through an individual gas inlet channel, or nozzle openings are divided into groups and the openings of each group communicate through corresponding gas inlet channels.

The nozzle openings are disposed on the dish-shaped nozzle body at positions allocated along a plurality of circular zones, which are concentric with each other around the centre axis of the bottom of the reaction vessel. In the context of the present invention, the concentric circular zones may include, for example, a central circular area the centre of which coincides with the centre axis of the reaction vessel. In this case, a central nozzle opening the centre of which coincides with the centre axis of the reaction vessel is provided in addition to the other nozzle openings allocated along at least one concentric circular zone having a radius from the centre axis. According to the invention, the nozzle openings are allocated along each of the concentric circular zones so as to eliminate the deviation of an inflow gas in the reaction vessel.

Also, it is preferable that the allocated positions of the nozzle openings are dispersed as uniformly as possible over the entire region occupied by a dish-shaped nozzle body in the centre part of the reaction vessel bottom in order to further equalize the supply of a coating material mixed gas into the fluidized-bed reaction vessel. For that purpose, the nozzle openings are disposed on the nozzle body at positions allocated along a plurality of circular zones, which are concentric with each other around the centre axis of the bottom of the reaction vessel. The nozzle openings may be allocated at equiangularly spaced intervals along each of the concentric circular zones which are concentric with each other around the centre axis of the bottom of the reaction vessel, and in this case it is possible to uniformly supply a coating material mixed gas despite the simplest design.

In case where a single gas inlet channel communicates with all of the nozzle openings, it is preferable that the inclination of directions of the branched channels radially extending from the single gas inlet channel increases as the associating nozzle openings are further from the centre to the inner peripheral region of the reaction vessel. In this case, the jet of a coating material mixed gas supplied from the nozzle openings of the branched gas inlet channels on the inner peripheral region is directed radially toward the inner peripheral wall of the reaction vessel, and therefore a sufficient flow of the coating material mixed gas is supplied to the inner peripheral region within the vessel to which a coating material mixed gas has been supplied insufficiently under ordinary circumstances. As a result, a coating material mixed gas can be supplied to the entire vessel chamber more uniformly.

Further, since the supplied jet velocity of the ejected coating material mixed gas generally reduces with distance from the position of the centre axis of the gas inlet nozzle toward the inner peripheral region of the reaction vessel, it is preferable to design the nozzle openings so that the nozzle openings at positions on an identical concentric circular zone may have an identical opening area and the nozzle openings located on a region remote from the centre axis may have a larger opening area than the nozzle openings located on a region close to the centre axis. In this case, it is possible to control the amount of the ejected gas supplied from the nozzle openings on the region remote from the centre axis to an even level as that of the gas supplied from the nozzle opening on the region close to the centre axis, thereby supplying the coating material mixed gas more uniformly into the entire vessel chamber.

Preferably, the dish-shaped nozzle body has a concavely curved surface so that fuel kernels blown up by a fluidizing gas may come back again to the centre region above the nozzle body and may tumble easily. In this case, the best way is to form the bottom surface of the reaction vessel including the surface of the dish-shaped nozzle body into a continuous concavely curved surface so that the overall surface may be formed as an identical concavely curved surface.

Also it is the case that the gas inlet nozzle may sometimes suffer clogging, damage, and others during long-term usage. In such a case, according to the present embodiment, it is possible to change only the nozzle body, which is detachably fitted into the bottom of the reaction vessel and constitutes at least a part of the centre part of the vessel bottom. For the joint between the gas inlet pipe and the nozzle body, it is preferable to employ a hermetically sealed joint mechanism so as to avoid the leakage of a supplied coating material mixed gas.

For example, it is possible to obtain the state where a gas inlet nozzle is attached with high sealability by disposing a cylindrical gas inlet in a protruding manner at the outer bottom part of a dish-shaped nozzle body, forming a female screw part around the inner periphery of the cylinder on the one hand, forming a male screw part, which screws together with the female screw part, around the outer wall at the end on the downstream side of a gas inlet pipe on the other hand, and screwing both the male and female screw parts together wit each other. It is needless to say that the joint is not limited to the screwing but various kinds of joint mechanisms may be adopted and the joints are not particularly limited as long as the joints have a detachable and attachable mechanism securing a hermetic joint.

Further, with regard to the gas inlet channel for the nozzle openings, it is also possible to form a gas inlet pipe for the respective gas inlet channels each of which communicates with a plurality of nozzle openings and adjust the pressure of each gas inlet pipe. For example, with regard to the nozzle openings allocated at equiangularly spaced intervals along circular zones which are concentric with each other around the centre axis of a reaction vessel bottom, it is possible to form a plurality of gas inlet channels for each of the concentric circular zones and a plurality of gas inlet pipes for the gas inlet channels allocated along the respective concentric circular zones to control the pressure and/or flow rate of the fed gas flowing through each of the gas inlet pipes independently.

With regard to the control of the pressure and the flow rate of the fed gas flowing through each of the gas inlet pipes, since control for balancing the pressure of each fed gas with the flow rate thereof is required, it is preferable to install a controller provided with input and output terminals leading to a gas pressure and flow rate regulator and control the pressure and the flow rate with software describing that flow rate conditions are prescribed. The pressure and the flow rate of each fed gas may be monitored during operation, and predetermined actions may be taken when the pressure or the flow rate deviates from a desired range or on some other occasions.

The location of the gas inlet pipes may arbitrarily be determined and it is possible to supply a gas only from a specific gas inlet pipe selected from among the gas inlet pipes disposed. In addition, it is possible to improve the fluidity of particles by adopting intermittent switching of the introduction of the fed gas into the gas inlet pipes. For example, the fluidity of particles improves by repeating the operations of opening a main gas inlet for 0.5 second and immediately thereafter opening an auxiliary gas inlet for 0.2 seconds.

In order to prevent particles from staying at a certain place in a reaction vessel, it is also possible to dispose an opening for gas ejection aimed at blowing away the particles in the vicinity thereof, the opening being communicated with a gas inlet pipe through a gas inlet channel.

It is also possible to connect the nozzle openings allocated at equiangularly spaced intervals to each other with a groove formed along a concentric circular zone to form a sleeve-shaped circular groove entirely. Further, it is possible to form a structure having the equivalent degree of durability as a conventional structure has by protecting the circumference of the opening of the circular groove with a shield member. Here, since the shield member formed around the opening of the circular groove is required to have thermal resistance, it is preferable to form the shield member with, for example, graphite. The graphite shield member does not require precise processing and finishing work of a gas inlet port unlike a conventional nozzle, and hence has the advantage of allowing the manufacturing cost to be reduced considerably.

At least one of said gas inlet channels may be branched into first and second sub-inlet channels, each of the first sub-inlet channels being communicated with each of said nozzle openings (hereinafter, referred to as "first nozzle openings") allocated at equiangularly spaced intervals along a first circular zone and each of said second sub-inlet channels being communicated with each of said nozzle openings (hereinafter, referred to as "second nozzle openings") allocated at equiangularly spaced intervals along a second circular zone, said first circular zone and second circular zone being concentric with each other around the centre axis of the reaction vessel bottom, wherein the inner diameter D of the reaction vessel, the diameter rs of the first circular zone, the number Ns of the first sub-inlet channels communicating with the first nozzle openings which are allocated along the first circular zone, the inner diameter ds of each of the first sub-inlet channels, the diameter rm of the second circular zone, the number Nm of the second sub-inlet channels communicating with the second nozzle openings allocated along the second circular zone, and the inner diameter dm of each of the second sub-inlet channels, simultaneously satisfy the conditions stipulated by the following expressions (1) to (3).

$$0.15 \leq rm/D \leq 0.22 \qquad (1)$$

$$rs/D \leq 0.08 \qquad (2)$$

$$Ns \times ds^2/(Ns \times ds^2 + Nm \times dm^2) < 1/3 \qquad (3)$$

As shown in the above expressions, the first nozzle openings are located at positions closer to the centre axis of the reaction vessel bottom and the second nozzle openings are located at positions closer to the inner peripheral wall than the first nozzle openings. Then at positions where the above expressions (1) to (3) are satisfied, a coating material mixed gas ejected from the second nozzle openings mainly fluidizes fuel kernels and forms a coating layer, and a coating material mixed gas ejected from the first nozzle openings mainly blows up fuel kernels in the vicinity of the centre part of the bottom of a reaction vessel and supplies the fuel kernels to the vicinities of the second nozzle openings.

Consequently, with a gas inlet nozzle according to the present invention, a coating material mixed gas is ejected from the nozzle openings allocated at equiangularly spaced intervals along the first and second concentric circular zones on the bottom of the reaction vessel so as to simultaneously satisfy the conditions stipulated by the above three expressions, thereby the supply of the coating material mixed gas into the reaction vessel is equalized all over in comparison with a conventional single nozzle, hence not only the fluidization of fuel kernels is equalized but also the formed coating layer is homogenized, and resultantly coated fuel particles of good and uniform quality can be obtained.

When the diameter rm of the second circular zone which determines the positions of the second nozzle openings relative to the centre axis of the reaction vessel bottom does not satisfy the expression (1) and the value of rm/D is less than 0.15, the second nozzle openings come too much closer to the centre of the reaction vessel bottom, hence the flow of a coating material mixed gas weakens gradually toward the peripheral wall of the reaction vessel in the same way as the case of a conventional single nozzle, and thus uniform fluidization of fuel kernels is hardly obtained. On the other hand, when the value of rm/D exceeds 0.22, the positions of the second nozzle openings are too close to the peripheral wall of the reaction vessel and resultantly, although the fluidization of fuel kernels in the region closer to the peripheral wall is satisfactory, the fluidization in the centre region of the reaction vessel deteriorates.

Further, when the diameter rs of the first circular zone which determines the positions of the first nozzle openings relative to the centre axis of the reaction vessel bottom does not satisfy the expression (2) and the value of rs/D is larger than 0.08, it becomes impossible to well fluidize the fuel kernels existing in the vicinity of the centre part of the reaction vessel bottom toward the vicinities of the second nozzle openings on the outer side.

In addition, when the total of the cross-sectional inner areas of the first sub-inlet channels is more than one third of the total of the cross-sectional inner areas of both the first and second sub-inlet channels, the blowoff of a gas increases excessively in the centre region, the flow of a coating material mixed gas weakens toward the inner peripheral region of the vessel in the same way as the case of a conventional single nozzle, and uniform fluidization of fuel kernels is hardly obtained.

The inner diameters of the first and second sub-inlet channels and the positions of the nozzle openings stated above are correlated with each other and it is necessary to simultaneously satisfy the above expressions (1) to (3) in order to supply stably and uniformly a coating material mixed gas into a reaction vessel and secure uniform fluidization of fuel kernels in an apparatus for manufacturing coated fuel particles for a high temperature gas-cooled reactor.

The second sub-inlet channels may be arranged so as to have such inclination angles to the centre axis of the reaction vessel bottom that the heights of the points at which the extensions of the centre axes of the second sub-inlet channels intersect with the inner wall of the reaction vessel are not lower than the height of the upper surface of fuel kernels charged in the reaction vessel. In this case, it is possible to form a coating layer uniformly on overall fuel kernels of one batch amount charged in a reaction vessel. In contrast, if the inclination angles of the second sub-inlet channels to the centre axis are such that the heights of the points at which the extensions intersect with the inner wall of the reaction vessel are lower than the height of the upper surface of the fuel kernels charged, the fuel kernels existing above the level of that height are not fluidized well and it is impossible to form a uniform coating layer on overall fuel kernels. In order to form all of the coating layers, for example from the aforementioned first coating layer to the fourth coating layer, uniformly until the end of the process, the conditions must be satisfied in all coating layer forming processes until the end of the final coating process.

The apparatus for manufacturing coated fuel particles for HTGRs, which includes the aforementioned gas inlet nozzle, may comprise a housing with a housing body having an opening at a part of the peripheral wall thereof and a front door attached to the housing body to open and close the opening of the housing body, the heater being separated into a first segment heater and a second segment heater, the insulating member being separated into a first segment insulating member and a second segment insulating member, both the first segment heater and the first segment insulating member being attached to the housing body, the second segment heater and the second segment insulating member being attached to the front door, and the first segment insulating member on the housing body and the second segment insulating member on the front door being configured so as to tightly touch with each other in the state where the opening is closed with the front door.

Preferably, the front door may be hinged on the housing body.

Also, it is preferable that the front door is attached to the housing body so as to be slidable upward or downward and equipped with a slide operating means for opening and closing the front door.

The apparatus for manufacturing coated fuel particles for HTGRs, which includes the aforementioned gas inlet nozzle, may comprise a fluidized-bed reaction vessel with a set of cylindrical members mutually connected in the form of a plurality of detachable stages to form a single cylindrical vessel structure, and that connection means for securing a tight seal is formed at each of the mutual connection portions between cylindrical members.

Consequently, in the event of maintenance work such as the exchange of a reaction vessel, the cleaning of the interior of a reaction vessel, or the like, it is possible to handle the reaction vessel in the state of separating it into individual cylindrical members and hence operability improves and, when a series of consecutive coating processes for consecutively forming the first to fourth coating layers are repeated and a large amount of coated fuel particles are manufactured for example, the maintenance operation for each consecutive coating process is simplified and facilitated and thus the efficiency of the entire operation processes improves.

In general the bottom end of a reaction vessel is a place where a gas for the fluidization of fuel kernels is ejected and also a place where deterioration appears at the earliest as the fluidizing state of particles is repeated. In the reaction vessel, it is possible to change a part of each connection stage in accordance with the degree of deterioration, for example to change only a cylindrical member including the bottom end, and hence it is possible to improve the economic efficiency and reduce the amount of waste in comparison with the conventional case where the entire reaction vessel has been changed even with partial deterioration. In addition, in the manufacturing of a reaction vessel too, it is easier to manufacture cylindrical members separated in pieces and downsized than to manufacture a single large sized cylindrical vessel, and in that case it is possible to manufacture a reaction vessel with better dimensional accuracy.

Further, in forming a coating layer, respective cylindrical members are connected to each other and formed into a single cylindrical body and a reaction vessel thus fabricated is used. In this case, if a sealed state of a reaction vessel is obtained with a connection means disposed at each of the connection areas between cylindrical members connected to each other, the leakage of a gas and the adhesion of fuel kernels are avoided between the cylindrical members and there are no problems in the thermal decomposition reaction for the forming of a coating layer and the safety of the apparatus.

As such a connection means, any mechanical system may be adopted as long as a sufficient seal performance of an entire reaction vessel is obtained. Preferably, the connection means is designed to facilitate detaching and attaching operations so as to finish the operations for a very short period of time. The connection means may comprise a male screw portion formed around the outer periphery at one end of each of said cylindrical members and a female screw portion formed around the inner periphery at other end of each of said cylindrical members so that the female screw portion and the male screw portion screws each other at each of the mutual connection portions between said cylindrical members.

With regard to the number of stages of the separation of a reaction vessel in the present embodiment, a number of stages of good operability may properly be selected in accordance with the design including the size and the weight of the reaction vessel necessary for the actual coating process. Further, with regard to the dimension including the height of each cylindrical member, a dimension of good operability may be selected in accordance with the design including the weight of each cylindrical member and the like.

The apparatus for manufacturing coated fuel particles for HTGRs, which includes the aforementioned gas inlet nozzle, may comprise said cylindrical housing with a first space in which the gas inlet pipe exists to convey a coating material mixed gas into the fluidized-bed reaction vessel, a second space in which the heater and the insulating member exist, and means for isolating said first space and second space from each other.

Accordingly, also in the case of successive coating processes, the temperature distribution in the reactor which largely affects the properties of a coating layer does not vary and can be stabilized and thus an apparatus for manufacturing coated fuel particles for HTGRs suitable for successive coating processes can be obtained.

More specifically, this option relates to an improvement of the apparatus for manufacturing coated fuel particles of the fuel for HTGRs, particularly to an improvement of a fluidized-bed reaction apparatus for coating fuel kernels made of chemical compounds of uranium such as uranium dioxide with the aforementioned coating layers ranging from the first coating layer consisting of a low-density carbon layer to the fourth coating layer consisting of a high-density pyrolytic carbon layer.

In the present example, the first space in the fluidized-bed reaction apparatus where the gas inlet pipe exists to convey a coating material mixed gas into the reaction vessel and the second space in the fluidized-bed reaction apparatus where the heater and the insulating member exist are isolated from each other. Thus the coating material mixed gas leaked out from a gap between the gas inlet nozzle and the reaction vessel are prevented from flowing toward the heater and the insulating member and hence it is possible to prevent graphite which is a typical material of the heater and the insulating member from reacting with hydrogen and thus prevent the graphite from suffering wear and damage.

Since the wear and damage of the heater and the insulating member are avoided, even in the case of successive coating processes, the temperature distribution in the reactor does not vary and is stabilized. As a consequence, it is possible to stabilize the quality of a coating layer, which plays a very important role in the function of confining the fissionable materials in fuel for a high temperature gas-cooled reactor.

With regard to the isolation between the aforementioned two spaces, any means is acceptable as long as the means can prevent the leak gas within the first space where the gas inlet pipe to the reaction vessel exists from flowing into the second space where a heater and an insulating member exist in the housing body. Preferably, the isolation means comprises a cylindrical caulking member which surrounds the outer periphery of the gas inlet pipe, the lower end of which is fixed to the bottom portion of the housing body, and the upper end of which has a screw portion to be connected to the bottom portion of the reaction vessel at the outer periphery of the gas inlet nozzle.

Yet preferably, the outer periphery of the cylindrical caulking member may further be covered with a graphite-made insulating member so that the first and second spaces can more surely be isolated from each other. In addition, the gas inlet pipe, which is typically made of metal, can be prevented from melting.

In another example, the isolation means comprises a cylindrical caulking member which is installed on the bottom portion of the reaction vessel at the outer periphery of the gas inlet nozzle and extended downward to surround the outer periphery of the gas inlet pipe, and the lower end of the cylindrical caulking member is fixed to the bottom portion of the housing body to prevent the leakage of a gas within the first space from flowing into the second space. Otherwise the isolation means may comprise a cylindrical caulking member which is integrated with the bottom portion of the reaction vessel at the outer periphery of the gas inlet nozzle and extended downward to surround the outer periphery of the gas inlet pipe, the lower part of the cylindrical caulking member has a screw portion to be connected to the bottom portion of the housing body so that a coating material mixed gas leaked out from a gap between the gas inlet nozzle and the reaction vessel are prevented from flowing from the first space toward the second space in which the heater and the insulating member are arranged.

With the adoption of the isolation means as mentioned above, even if hydrogen gas, which plays the role of the fluidizing gas when the aforesaid third coating layer or SiC layer is applied, leaks out from a gap between the gas inlet nozzle and the reaction vessel to the first space, the leakage is within the first space surrounded by the cylindrical caulking member between the reaction vessel bottom and the housing body bottom, and the second space, that is the outside of the first space, is not affected by the leakage. Consequently, in the second space, it is possible to prevent graphite, which is a material of the heater and the insulating member, from reacting with hydrogen and thus prevent the graphite from suffering wear and damage. Since the wear and damage of the heater and the insulating member are avoided, even in the case of successive coating processes, the temperature distribution in the reactor does not vary and is stabilized. As a consequence, it is possible to stabilize the quality of a coating layer, which plays a very important role in the function of confining the fissionable materials in fuel for HTGRs.

The apparatus for manufacturing coated fuel particles for HTGRs, which includes the aforementioned gas inlet nozzle, may further comprise an inert gas inlet pipe for introducing inert gas into the region on the outside of the fluidized-bed reaction vessel in the cylindrical housing and control means for controlling the pressure of the inert gas in said region to a pressure equal to or higher than the inner pressure of the fluidized-bed reaction vessel.

Consequently, even in the case of successive coating processes, it is possible to stabilize the temperature distribution in the reactor and also stabilize the quality of a coating layer which plays a very important role in the function of confining the fissionable materials in fuel for HTGRs. That is, the present example makes it possible to prevent a coating material mixed gas from leaking out from a gap between the gas inlet nozzle and the reaction vessel and also prevent the graphite which is a typical material of the heater and the insulating member from reacting with hydrogen and suffering wear and damage by pressurizing the region on the outside of the fluidized-bed reaction vessel in the cylindrical housing with an inert gas such as an argon gas or a nitrogen gas and raising the pressure in the region to a pressure equal to or higher than that in the reaction vessel.

Further, since the wear and damage of the heater and the insulating member are avoided, even in the case of successive coating processes of fuel particles, the temperature distribution in the reactor does not vary and is stabilized. As a consequence, it is possible to stabilize the quality of a coating layer, which plays a very important role in the function of confining the fissionable materials in fuel for HTGRs.

As an inert gas introduced into the region outside the fluidized-bed reaction vessel in the cylindrical housing according to the present example, it is preferable to use a gas which hardly reacts with the constituent material of the reaction vessel, such as nitrogen gas, or a rare gas such as argon, neon, helium or the like. Particularly, argon gas, which is also used as the fluidizing gas, is preferably adopted for the inert gas.

With regard to the control means in the present example, a gas in a reaction vessel hardly leaks outside thereof if the pressure of the inert gas is controlled to a pressure higher than the inner pressure of a fluidized-bed reaction vessel. In this case, however, if the pressure of the inert gas introduced into the region outside the fluidized-bed reaction vessel in the cylindrical housing is too high above the inner pressure of the vessel, there is the fear that the inert gas inversely intrudes into the reaction vessel and that causes the ratio of a coating gas to a fluidizing gas (entrained with the inert gas) contained in the coating material mixed gas to vary. To cope with that, it is preferable to control the supply pressure of the inert gas to a pressure at least equal to or somewhat higher than the inner pressure of the fluidized-bed reaction vessel.

With regard to the multilayered coating layers on fuel kernels, in the event of forming each of the coating layers, the supply flow rates of a coating gas and of a fluidizing gas are different from each other depending on the nature of each of the coating layers and therefore the pressure in the reaction vessel also varies with respect to each of the coating layers to be formed. For that reason, the control means may be adapted for controlling the value of the pressure of the inert gas to be introduced into the region on the outside of the fluidized-bed reaction vessel in the cylindrical housing in accordance with the respective sorts of the coating layers to be formed.

According to a preferable embodiment of the present invention, the apparatus for manufacturing coated fuel particles for HTGRs, which includes the aforementioned gas inlet nozzle, further comprises:

a sweep gas feed pipe for supplying a sweep gas into a space outside the fluidized-bed reaction vessel within the cylindrical housing in order to purge a coating material mixed gas leaked out from the reaction vessel to the exterior of the cylindrical housing; and

a circumferential inner flow channel disposed between the fluidized-bed reaction vessel and the insulating member with a clearance of a uniform width all around the circumference thereof so as to stream the sweep gas without stagnation.

In this embodiment, even in the case of successive coating processes, it is possible to stabilize the temperature distribution in the reactor so as to stabilize the quality of a coating layer and avoid stagnating or deviating the flow of a sweep gas, thereby preventing the heater and the insulating member from partially deteriorating.

More specifically, this embodiment also relates to an improvement of the apparatus for manufacturing coated fuel particles of the fuel for HTGRs, particularly to an improvement of a fluidized-bed reaction apparatus for coating fuel kernels made of chemical compounds of uranium such as uranium dioxide with the aforementioned coating layers ranging from the first coating layer consisting of a low-density carbon layer to the fourth coating layer consisting of a high-density pyrolytic carbon layer.

According to a specific feature of the present embodiment, the sweep gas is introduced to flow in the region outside the reaction vessel within the housing so that a coating material mixed gas leaked out from a gap between the gas inlet nozzle and the reaction vessel is purged away to the exterior of the housing. Even though hydrogen gas as the fluidizing gas leaks out from the gap between the gas inlet nozzle and the reaction vessel during the forming process of an SiC layer or the aforementioned third coating layer, the leak gas is purged to the exterior of the housing with the sweep gas and hence it is possible to prevent the graphite which is a constituent material of the heater and the insulating member from reacting with hydrogen and suffering wear and damage.

Since the wear and damage of the heater and the insulating member are avoided, even in the case of successive coating processes, the temperature distribution in the reactor does not vary and is stabilized. As a consequence, it is possible to stabilize the quality of a coating layer which plays a very important role in the function of confining the fissionable materials in fuel for a high temperature gas-cooled reactor.

In a conventional fluidized bed, the vertical housing is provided with a planar door for maintenance on a partial region of the sidewall thereof and as a result the shape of the housing in horizontal cross section is not circular form. Consequently, there have been the problems in that in the region outside the reaction vessel within the housing, the flow rate of the circumferential component of the sweep gas flow is varied between the region extending along the inner surface of the door and the region extending along the inner peripheral wall of the housing body since in the region extending along the inner surface of the door, the flow channel is narrower and the fluid resistance for the gas flow is higher than those in the region extending along the inner peripheral wall of the housing body, hence the flow increases disproportionately in the region extending along the inner peripheral wall of the housing body, and thus the respective parts of the heater and the insulating member disposed behind the door are selectively deteriorated. To cope with the problems, in a preferable embodiment according to the present invention, the apparatus further comprises an outer flow channel disposed between the insulating member and the cylindrical housing with a clearance of a uniform width all around the circumference thereof so as to stream the sweep gas without stagnation.

In this case, even if hydrogen gas, which plays the role of the fluidizing gas when the third coating layer is formed, leaks out from a gap between the gas inlet nozzle and the reaction vessel, it is possible to allow said sweep gas to flow smoothly all around in the circumference in the cylindrical housing. Consequently it is possible to prevent graphite, which is a typical material of the heater and the insulating member, from reacting locally with hydrogen and thus prevent the graphite from suffering local wear and damage. Since the wear and damage of the heater and the insulating member are avoided, even in the case of successive coating processes, the temperature distribution in the reactor does not vary and is stabilized. As a consequence, it is possible to stabilize the quality of a coating layer, which plays a very important role in the function of confining the fissionable materials in fuel for HTGRs. With regard to the outer flow channel and/or the inner flow channel, any channel shape is acceptable as long as the channel is formed all around the circumference in the cylindrical housing with a clearance of a uniform width so that the sweep gas flows smoothly without stagnation in the channel. The reaction vessel, the insulating member and the housing may be formed into cylindrical shapes in different diameters respectively and are disposed concentrically wit each other to form the respective circular channels among them.

A door constituting a part of the peripheral wall of the cylindrical housing may be disposed on the housing body for ease of maintenance. That is, the door is disposed on the peripheral wall of the cylindrical housing for ease of maintenance such as the attachment and detachment of the reaction vessel or the nozzle body, the cleaning of the interior of the housing or the reaction vessel and the like, and the shape of the door is configured so as to be a part of the peripheral wall of the housing, thereby making it possible to flow a sweep gas smoothly all around in the circumference direction in the cylindrical housing. As a consequence, it is possible to prevent the graphite, which is a material of the heater and the insulating member, from reacting locally with hydrogen and suffering local wear and damage.

The sweep gas used in the apparatus according to the present invention, plays the role of purging and sweeping away a coating material mixed gas leaked out from the fluidized-bed reaction vessel to the exterior of the housing, and is required not to react with any constituent metal/graphite members inside the housing at a high temperature. The sweep gas, for example, may be an inert gas such as a nitrogen gas, an argon gas, or the like.

In the present embodiment, the sweep gas feed pipe plays the role of supplying a sweep gas into a space outside the fluidized-bed reaction vessel within the cylindrical housing in order to purge a coating material mixed gas leaked out from the reaction vessel to the exterior of the cylindrical housing. Consequently, it is preferable that the feed pipe supplies the sweep gas from the bottom of the housing upward to the outer periphery of the reaction vessel, and the housing is correspondingly provided with an exhaust port for the sweep gas on the upper region above the reaction vessel.

A sweep gas supplied from the sweep gas feed pipe may be discharged to the exterior through an exhaust port exclusively disposed for the discharge of the sweep gas. In case an inert gas is used as the sweep gas, however, since the sweep gas does not react with the constituent metal/graphite members at a high temperature, there is no problem even if the sweep gas is mixed into the coating gas and/or fluidizing gas from the vessel. Preferably therefore, the sweep gas flowing in the space outside the reaction vessel within the housing may be discharged from the space through an exhaust port commonly disposed for the discharge of the coating material mixed gas from the reaction vessel to the exterior of the housing and thereby the need for the installation of an additional exhaust port is eliminated.

According to an alternative embodiment of the present invention, the apparatus for manufacturing coated fuel particles for HTGRs, which includes the aforementioned gas inlet nozzle, further comprises a suction pump for discharging a coating material mixed gas leaked out from the fluidized-bed reaction vessel to the exterior of the housing.

Consequently, the distribution of the coating temperature in the reaction vessel which largely affects the properties of a coating layer formed does not vary and is kept uniform even if a number of processes are repeated and it is possible to provide an apparatus for manufacturing coated fuel particles for HTGRs, which apparatus is suitable for successive coating processes.

More specifically, this embodiment also relates to an improvement of the apparatus for manufacturing coated fuel particles of the fuel for HTGRs, particularly to an improvement of a fluidized-bed reaction apparatus for coating fuel kernels made of chemical compounds of uranium such as uranium dioxide with the aforementioned coating layers ranging from the first coating layer consisting of a low-density carbon layer to the fourth coating layer consisting of a high-density pyrolytic carbon layer.

In this embodiment, the pressure in the space outside the reaction vessel within the housing is reduced by the suction pump, and a coating material mixed gas leaked out from a gap between the gas inlet nozzle and the reaction vessel is sucked and discharged to the exterior of the housing which accommodates the heater and the insulating member therein. Thereby, even when hydrogen gas as the fluidizing gas leaks out from the gap between the gas inlet nozzle and the reaction vessel during the formation process of the aforementioned third coating layer or SiC layer, the leak gas is evacuated to the exterior of the housing with the suction pump or a vacuum pump and hence it is possible to prevent the graphite which is a typical material of the heater and the insulating member from reacting with hydrogen and suffering wear and damage.

Since the wear and damage of the heater and the insulating member are avoided, even in the case of successive coating processes, the temperature distribution in the reaction vessel does not vary and is stabilized. As a consequence, it is possible to stabilize the quality of a coating layer, which plays a very important role in the function of confining the fissionable materials in fuel for HTGRs.

With regard to the suction pump used in this embodiment, any types of suction pump may be adopted as long as it can discharge a coating material mixed gas leaked out from a fluidized-bed reaction vessel to the exterior of the housing. Preferably, a low-vacuum pump, such as a rotary pump, a mechanical booster pump or the like, is employed as said suction pump. Further, in the formation process of each of the aforementioned first, second, and fourth coating layers, a flammable coating gas is used and hence a suction pump of explosion-proof specification is preferable to use.

Another preferable design of the suction pump according to the present embodiment includes a suction pipe communicating at least the interior of the housing with the suction port of the suction pump. As the suction pipe, any pipe may be adopted as long as it passes through the wall of the housing and sucks a gas therein. Preferably, the suction pipe may have a suction opening in the vicinity of or above a gap between the gas inlet nozzle and the reaction vessel where a coating material mixed gas is likely to leak out so that the leak gas can be well sucked into the suction opening.

The suction pump may be operated in all the processes of forming the aforementioned first to fourth coating layers. However, reaction between hydrogen gas and graphite may cause a considerable problem in the process of forming the third coating layer or SiC layer and hence it is preferable to operate the suction pump particularly in the process of forming the SiC layer.

When the suction pump is operated, the inner pressure of the housing decreases below the inner pressure of the gas inlet nozzle and reaction vessel. If the housing inner pressure decreases excessively, it causes a coating material mixed gas to leak from a gap between the gas inlet nozzle and reaction vessel in large quantity. Consequently, it is preferable to supply an inert gas from an inert gas supply bottle to the interior of the housing at the same time as the suction pump is operated so as to purge the leak gas concomitantly with the inert gas. Preferably, the inert gas is supplied to a position opposite to the gap portion between the gas inlet nozzle and the reaction vessel on the other side of the suction opening of the suction pipe so that the leaking gas is purged by the inert gas more effectively.

According to an preferable embodiment of the present invention, the apparatus for manufacturing coated fuel particles for HTGRs the gas feed system comprises an evaporation tank for generating a coating material mixed gas to be supplied into the reaction vessel when a silicon carbide layer is formed and temperature adjusting means for thermostatically controlling the operational temperature of the evaporation tank.

In this case, the silicon carbide layer can be formed stably while the thickness and the density of the silicon carbide layer formed as the aforementioned third coating layer are not influenced.

With regard to the temperature adjusting means, any physical means can be adopted as long as it thermostatically controls the operational temperature of the evaporation tank retaining a silicon carbide compound (methyltrichlorosilane in most cases), which functions as the silicon carbide source to be mixed with a fluidizing gas ($H_2$ carrier gas for example) and then supplied into the fluidized-bed reaction vessel, to a predetermined temperature during the forming of the silicon carbide layer. Specifically, any physical means may be adopted as long as it can thermostatically control the temperature of a coating material mixed gas (mixed gas of $H_2$ and methyltrichlorosilane). In the concrete adjustment of the temperature of the coating material mixed gas when it is generated, it is preferable to be able to thermostatically control the temperature of the liquid phase methyltrichlorosilane to an accuracy of 1 °C in the temperature range from 20 to 50 °C. More specifically, the temperature adjusting means may be adapted to control a temperature to an accuracy of plus/minus 1 °C in the temperature range from 20 to 50 °C. Further, the temperature of the coating material mixed gas in the gas feed lines of the gas feed system is not particularly restricted as long as the temperature is maintained to a temperature at which the methyltrichlorosilane containing gas is not liquidized.

Thus, a preferable concrete embodiment includes temperature adjusting means which can thermostatically control the operational temperature in the evaporation tank for generating a coating material mixed gas to an accuracy of plus/minus 1 °C in the temperature range from 20 to 50 °C. In this case, it is possible to keep the amount of a generated methyltrichlorosilane evaporated gas stable, and resultantly obtain a stable silicon carbide layer while the thickness and the density thereof are not influenced.

According to another preferable embodiment of the present invention, the apparatus for manufacturing coated fuel particles for HTGRs, the gas feed system comprises an evaporation tank for generating a coating material mixed gas to be supplied into the reaction vessel, a line pipe constituting a gas feed line for feeding said coating material mixed gas from the evaporation tank to the fluidized-bed reaction vessel, and temperature retaining means for retaining the temperature of the line pipe over a predetermined temperature when a silicon carbide layer is formed.

In this case, the silicon carbide layer can be formed stably while the thickness and the density of the silicon carbide layer formed as the aforementioned third coating layer are not influenced.

The temperature retaining means is preferably adapted to control the temperature of the surface of the line pipe which constitutes a gas feed line ranging from the evaporation tank to the fluidized-bed reaction vessel to 40 °C or higher. In this case, it is possible to prevent a methyltrichlorosilane containing gas from being liquidized in the line pipe and resultantly obtain a stable silicon carbide layer as the aforementioned third coating layer while the thickness and the density of thereof are not influenced.

The temperature retaining means may include a temperature control means for controlling the temperature of the surface of the line pipe ranging from the evaporation tank to the fluidized-bed reaction vessel to 40 °C or higher. The temperature retaining means may also include a heat insulating cover for insulating the line pipe from the ambient temperature.

The gas feed system may further comprise a waste gas exhaust line leading to a waste gas treatment equipment to remove the coating material mixed gas remaining in the line pipe, the waste gas exhaust line being arranged as a bypass line in the gas feed line ranging from the evaporation tank for generating a methyltrichlorosilane containing gas to the fluidized-bed reaction vessel.

Fuel kernels produced by sintering uranium dioxide are used to form fuel particles for HTGRs after each of the kernels is coated with a total fourfold layer. Typically, the diameter range of the fuel kernels is from 0.4 to 0.7 mm, the sphericity thereof is 1.2 or less, and a batch amount of the fuel kernels charged into the fluidized-bed reaction vessel is 5.5 kg or less.

The apparatus for manufacturing coated fuel particles for HTGRs, which includes the aforementioned gas inlet nozzle, may comprise a gas feed system with an evaporation tank for generating a coating material mixed gas which contains methyltrichlorosilane as a coating material used for forming a silicon carbide layer on the surfaces of the fuel kernels, a vessel line pipe for introducing said coating material mixed gas into the fluidized-bed reaction vessel through a gas inlet pipe, and a methyltrichlorosilane feed pipe for supplying said coating material mixed gas containing methyltrichlorosilane from said evaporation tank to said vessel line pipe, said evaporation tank being provided with a gas outlet placed at a position above the gas inlet pipe, and the methyltrichlorosilane feed pipe being placed downward at least over the range from the gas outlet of said evaporation tank to a confluent portion thereof with the vessel line pipe.

Normally, methyltrichlorosilane is a liquid material. Therefore, the liquid methyltrichlorosilane contained in the evaporation tank is subjected to bubbling by injecting hydrogen gas as a carrier gas and as at least a part of a fluidizing gas, and then the vapour of the methyltrichlorosilane trapped in the bubbles while the bubbles ascend in the liquid is collected as a coating gas and sent from the gas outlet of the evaporation tank to the vessel line pipe through the methyltrichlorosilane feed pipe. Thus the coating material mixed gas is supplied from the vessel line pipe into the reaction vessel through the gas inlet pipe.

In the present example, the gas outlet of the evaporation tank is located at a position above the gas inlet pipe of the vessel line pipe and the methyltrichlorosilane feed pipe is laid downward ranging at least from the gas outlet of the evaporation tank to the confluent portion thereof communicating with the vessel line pipe. As a consequence, in the methyltrichlorosilane feed pipe where the accumulation of methyltrichlorosilane has heretofore been most likely to occur, the methyltrichlorosilane which tends to settle by the gravity is smoothly sent without interruption toward the vessel line pipe not in the upward direction but only in the downward direction following the gravity and hence the supply of the methyltrichlorosilane containing gas as the coating material mixed gas to the reaction vessel is more stabilized than ever.

The methyltrichlorosilane feed pipe may be placed so as to extend nearly in the vertical direction. That is, the evaporation tank is placed, for example, immediately above the confluent portion which communicates with the vessel line pipe so as to extend nearly in the vertical direction, thereby making it possible to feed the methyltrichlorosilane containing gas to the vessel line pipe most efficiently.

The confluent portion between the methyltrichlorosilane feed pipe and the vessel line pipe may comprise a collecting pipe communicating with a hydrogen gas pipe for supplying hydrogen gas for fluidizing the fuel kernels in the reaction vessel, the collecting pipe being placed at a position lower than the gas outlet of the evaporation tank and above the gas inlet pipe.

In this case, the confluent portion, at which the methyltrichlorosilane feed pipe communicates with the vessel line pipe, comprises a gas collecting pipe which communicates with the hydrogen gas pipe for feeding a high flow rate hydrogen gas as the fluidizing gas for fluidizing fuel kernels in the reaction vessel, and consequently the coating material mixed gas fed from the collecting pipe into the vessel line pipe is well introduced into the gas inlet pipe by the hydrogen gas flow of a high flow rate which is merged with the methyltrichlorosilane containing gas supplied from the evaporation tank through the methyltrichlorosilane feed pipe at the confluent portion. Hence the accumulation of the methyltrichlorosilane is little and causes no problem in the vessel line pipe within a range from the confluent portion to the gas inlet pipe.

In order to feed the methyltrichlorosilane containing gas more smoothly and realize more stable supply of the coating material mixed gas containing methyltrichlorosilane to the reaction vessel, however, it is also desirable to place the vessel line pipe so as to occur only descent stream of gas flow inside thereof in the range from the collecting pipe at the confluent portion to the gas inlet of the gas inlet pipe. In this case, the collecting pipe is placed at a position lower than the gas outlet of the evaporation tank and above the gas inlet pipe.

Effect of the Invention

According to the present invention, as the first advantageous effect in comparison with a conventional apparatus having a single nozzle, a coating material mixed gas supplied into a reaction vessel is equalized as a whole, not only the fluidization of fuel kernels but also the coating layers formed on the surfaces of the fuel kernels are also equalized, and the obtained coated fuel particles are homogenized and have high quality. In the case of forming an SiC layer as the aforementioned third coating layer in particular, the sediment of SiC which is generated when the SiC layer is formed is dispersed to a plurality of nozzle openings of the gas inlet channels and hence the sediment at the nozzle openings does not so grow as to clog the openings. Consequently, even when the apparatus is upsized, it is possible to avoid the danger of hindering the supply of the coating material mixed gas and hence form the SiC layer having a heavy thickness produced by long-term coating reaction, which has heretofore been difficult.

As the second advantageous effect in addition to the first effect, the apparatus is easily accessed by opening the front door and that makes it possible to be excellent in the operability of maintenance including the change, such as the attachment and the detachment, of the reaction vessel, the cleaning of the interior of the cylindrical housing or the like, and improve the efficiency of the entire manufacturing processing. Further, it is possible to separate the fluidized-bed reaction vessel into a set of cylindrical members mutually connected in plural detachable stages to form a single cylindrical vessel structure, and carry out the maintenance including the change of the reaction vessel, the cleaning of the interior of the reaction vessel or like in the state of the separated cylindrical members. As a result, handling is outstandingly facilitated and the operability improves even when the apparatus is upsized.

Further, as the third advantageous effect in addition to the first effect, it is possible to prevent the thermal insulating properties of the apparatus from deteriorating and not vary but stabilize the temperature distribution in the reactor vessel which largely affects the properties of the respective coating layers even in the case of successive coating processes. As a result, it is possible to obtain a manufacturing apparatus suitable for successive coating processes of the fuel particles even when the apparatus is upsized.

Furthermore, as the fourth advantageous effect in addition to the first effect, methyltrichlorosilane gas which has a heavier specific gravity than hydrogen carrier gas and is likely to settle by the gravity is smoothly fed toward the vessel line pipe in the direction not defying the gravity and hence it is possible to stably supply a coating material mixed gas for forming a silicon carbide layer, that is, the third coating gas, to the reaction vessel. As a result, it is possible to obtain a stable silicon carbide layer while the thickness and the density of the layer are not affected even when the apparatus is upsized.

Brief Description of the Drawings

Figs. 1a and 1b schematically show a gas inlet nozzle for an apparatus for manufacturing coated fuel particles for HTGRs according to one example of the present invention, where Fig. 1a is a plan view and Fig. 1b a sectional side view thereof.
Fig. 2 schematically shows an example of the configuration of the manufacturing apparatus to which the gas inlet nozzle according to the present example is attached.
Fig. 3 schematically shows another example of the configuration of the manufacturing apparatus to which the gas inlet nozzle according to the present example is attached.
Figs. 4a and 4b schematically show an example of the configuration of a reaction vessel equipped with a gas inlet nozzle according to the present invention, where Fig. 4a is a plan view of the bottom of the reaction vessel which bottom is formed by a dish-shaped nozzle body and Fig. 4b a sectional side view of the bottom portion of the reaction vessel.
Fig. 5 shows a front view of an apparatus for manufacturing coated fuel particles for HTGRs according to an example of the present invention.
Fig. 6 shows a front view of the manufacturing apparatus shown in Fig. 5 in which the front door is opened.
Fig. 7 schematically shows a sectional plan view of the reaction vessel of the apparatus shown in Fig. 5.
Fig. 8 shows a front view of an apparatus for manufacturing coated fuel particles for HTGRs according to another example of the present invention.
Fig. 9 shows a front view of the manufacturing apparatus shown in Fig. 8 in which the front door is opened.
Figs. 10a and 10b show an example of the structure of the reaction vessel according to one example of the present invention, where Fig. 10a is a sectional side view in which a plurality of cylindrical members are separated and Fig.

10b a sectional side view in which the cylindrical members are connected into a single cylindrical vessel structure.

Fig. 11 shows an exemplary configuration of an apparatus for manufacturing coated fuel particles for HTGRs according to the present invention.

Fig. 12 shows another exemplary configuration of an apparatus for manufacturing coated fuel particles for HTGRs according to the present invention.

Fig. 13 shows still another exemplary configuration of an apparatus for manufacturing coated fuel particles for HTGRs according to the present invention.

Figs. 14a and 14b show still another exemplary configuration of an apparatus for manufacturing coated fuel particles for HTGRs according to the present invention, where Fig. 14a is a sectional front view and Fig. 14b a sectional plan view thereof.

Fig. 15 shows still another exemplary configuration of an apparatus for manufacturing coated fuel particles for HTGRs according to the present invention.

Fig. 16 shows a schematic diagram of an gas feed system of an apparatus for manufacturing coated fuel particles for HTGRs according to one example of the present invention.

Fig. 17 schematically shows a configuration of pipes constituting a gas feed line ranging from an evaporation tank to the interior of a fluidized-bed reaction vessel.

Fig. 18 shows a schematic configuration of a gas feed line for supplying methyltrichlorosilane which is the material of the SiC coating layer in an apparatus for manufacturing coated fuel particles for HTGRs according to an example of the present invention.

Best Mode for Carrying Out the Invention

(A) Nozzle for Fluidized-bed Reaction Vessel:

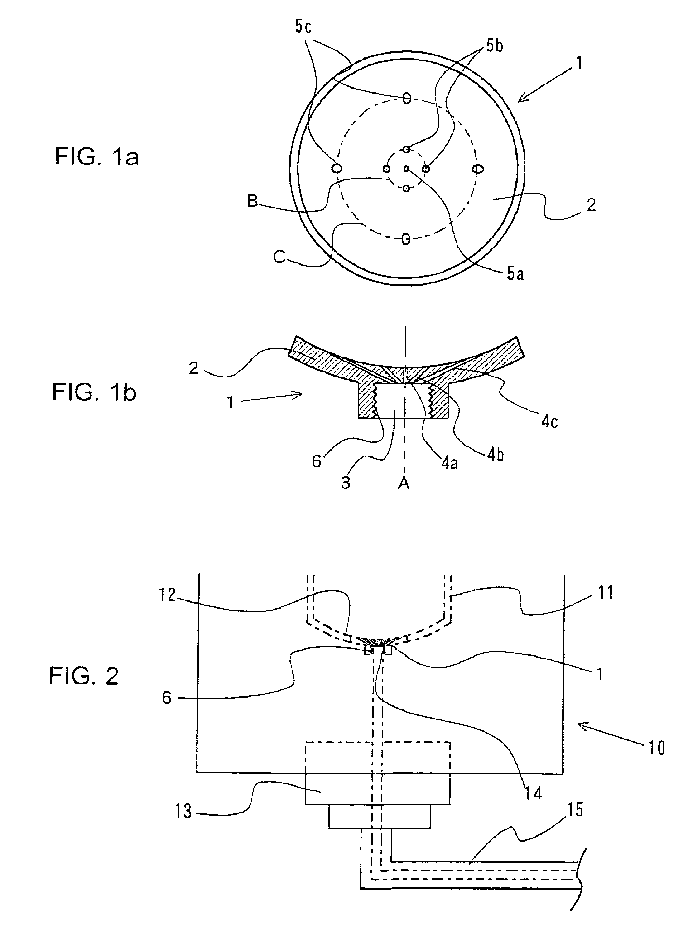

Figs. 1a and 1b schematically show a gas inlet nozzle to be used in an apparatus for manufacturing coated fuel particles for a HTGR according to an example of the present invention. Fig. 1a shows a schematic plan view of the gas inlet nozzle viewed from above, and Fig. 1b a schematic sectional side view of the gas inlet nozzle shown in Fig. 1a. Fig. 2 shows a schematic configuration of one example of the apparatus for manufacturing coated fuel particles for the HTGR to which apparatus the gas inlet nozzle is attached. In this embodiment, a gas inlet nozzle 1 is detachably attached to a bottom 12 of a fluidized-bed reaction vessel 11 of an apparatus 10 for manufacturing coated fuel particles for the MTGR. The gas inlet nozzle 1 is fitted into the bottom 12 of the reaction vessel 11 to constitute the central part of the vessel bottom as shown in Fig. 2.

The gas inlet nozzle 1 mainly comprises a round dish-shaped nozzle body 2 and a cylindrical gas inlet 3 which is disposed on the back side thereof and communicates with an end of a gas inlet pipe 15 extending from a gas feed system, which is not shown in the figure, equipped outside the apparatus. The dish-shaped nozzle body 2 is fitted into the vessel bottom 12 so that the centre axis A thereof may coincide with the centre axis of the cylindrical fluidized-bed reaction vessel 11. The nozzle body 2 has a concavely curved surface, which continues from the vessel bottom surface when it is properly fitted into the vessel bottom. Hence the whole bottom surface of the reaction vessel 11 including the surface of the dish-shaped nozzle body 2 forms a continuous bowl-shaped concavely curved surface.

Here, in the present example, the gas inlet nozzle 1 is fitted to the vessel bottom 12 and has a cylindrical gas inlet 3 for connecting an end portion of a connecting pipe 13 which is connected to the gas inlet pipe 15 extending from a gas source disposed outside the apparatus 10. As the connecting mechanism between the gas inlet 3 and the connecting pipe 13, for example, it is possible to form a male screw portion 14 on the outer periphery of the end, on the side of the vessel, of the connecting pipe 13 on the one hand, and to form a female screw portion 6 which is screwed together with the male screw portion 14 of the connecting pipe 13 on the cylindrical inner periphery of the gas inlet 3 on the other hand, so that a hermetically secured connection is realized by screwing both the male and female screw portions together.

In this case, the gas inlet nozzle 1 can easily be detached from the vessel bottom 12 only by releasing the screwing of both the screw portions and hence it is possible to change only the nozzle 1 in a simple and easy manner in the event of the clogging or the wear and damage of the gas inlet nozzle 1.

In the nozzle body, a gas inlet channel is branched into a plurality of sub-inlet channels 4a, 4b and 4c, which pass through the dish-shaped nozzle body 2. Those sub-inlet channels are formed such that they are radially branched from the centre axis of the cylindrical gas inlet 3 toward the outer circumference to form a plurality of nozzle openings at predetermined dispersed positions on the surface of the vessel bottom as shown in Fig. 1. Those nozzle openings are disposed on the nozzle body at a central position aligned coaxially with the centre axis A and at positions allocated along a plurality of circular zones which are concentric with each other around the centre axis A of the reaction vessel bottom.

In the present example, the branched sub-inlet channels are designed so as to allocate one nozzle opening 5a on the centre axis A, four nozzle openings 5b having the identical shape and size respectively on a first circular zone B on the inner side, and four openings 5c having the identical shape and size respectively on a second circular zone C on the outer side at equally spaced intervals along each of the circular zones respectively. The branched sub-inlet channels are configured to uniformly disperse the nozzle openings 5a, 5b and 5c on the surface of the dish-shaped nozzle body 2 constituting the centre region of the reaction vessel bottom.

Furthermore, the nozzle openings are configured so that the area of a nozzle opening on an outer side is larger than that of a nozzle opening on an inner side. Thereby, although the supplied jet velocity of the ejected coating material mixed gas generally reduces with distance from the position of the centre axis A of a cylindrical gas inlet pipe toward the inner peripheral region in the reaction vessel, in the case of the gas inlet nozzle 1 according to the present example, the nozzle openings are so designed that the nozzle openings at positions on an identical concentric circular zone have an identical opening area and the nozzle openings located on an inner peripheral region have a larger opening area than the nozzle openings located on a region closer to the centre axis A, and consequently it is possible to control the amount of the ejected gas supplied from the nozzle openings on the inner peripheral region to an even level as that of the gas supplied from the nozzle opening 5a on the centre axis A, thereby supply a coating material mixed gas more uniformly into the entire inner chamber of the reaction vessel 11.

In a practical experience using a gas inlet nozzle 1 having such a configuration as stated above, the gas inlet nozzle 1 comprises a dish-shaped nozzle body 2 of 100 mm in outer diameter and 30 mm in thickness, in which nine sub-inlet channels 4a, 4b and 4c are branched from a cylindrical gas inlet 3 of 26 mm in inner diameter, 40 mm in outer diameter, and 15 mm in height to form a nozzle opening 5a of 3 mm in inner diameter at the position of the centre axis A, four nozzle openings 5b of 3 mm in inner diameter on a first circular zone B of 12 mm in diameter, and four nozzle openings 5c of 4 mm in inner diameter on a second circular zone C of 40 mm in diameter. The nozzle body 2 was attached to a reaction vessel 11 as shown in Fig. 2 and the reactions for forming coating layers on uranium dioxide fuel kernels were carried out in the following manner.

Firstly, about 3.8 kg of uranium dioxide fuel kernels of 0.6 mm in average diameter were charged into the reaction vessel 11, a first coating layer consisting of a low-density carbon layer was formed by supplying acetylene gas into the vessel through the gas inlet nozzle 1 at the temperature in the vessel of about 1,400 °C, and thereafter a second coating layer consisting of a high-density pyrolytic carbon layer was formed by supplying propylene at about 1,400 °C. Successively, a third coating layer consisting of an SiC layer was formed by supplying methyltrichlorosilane at about 1,600 °C, and finally a fourth coating layer consisting of a high-density pyrolytic carbon layer was formed by supplying propylene at about 1,400 °C.

The average diameter of the fourfold layered fuel particles obtained was 0.93 mm, and the thicknesses of the coating layers were 0.06 mm for the first coating layer, 0.03 mm for the second coating layer, 0.03 mm for the third coating layer, and 0.045 mm for the fourth coating layer respectively, and were very uniform. Further, whereas SiC sediment grew up to about 10 mm width at a nozzle opening and almost clogged the nozzle opening in the case of forming a third coating layer 0.025 mm thick with a conventional gas inlet nozzle, with the gas inlet nozzle 1 according to the present example, even after the third coating layer 0.03 mm thick was formed as stated above, the size of the sediment at the nozzle openings 5a to 5c of the gas inlet channels of the gas inlet nozzle 1 was restrained up to about 2 mm width, the nozzle openings were not clogged, and the forming reaction of the fourth coating layer was not hindered.

In the above experience, a total of nine sub-inlet channels 4a, 4b and 4c were formed so that their nozzle openings 5a, 5b and 5c were allocated at the position on the centre axis A and the respective four positions on each of the two stage circular zones. However, a gas inlet nozzle according to the present invention is not limited to the case, and the number of the sub-inlet channels and the positions of the nozzle openings may properly be selected for each gas inlet nozzle in accordance with the actual reaction vessel size and the gas supply amount. For example, the nozzle openings may be formed on three or more stage of the circular zones, and the sub-inlet channels may have four or more nozzle openings on each of the circular zones.

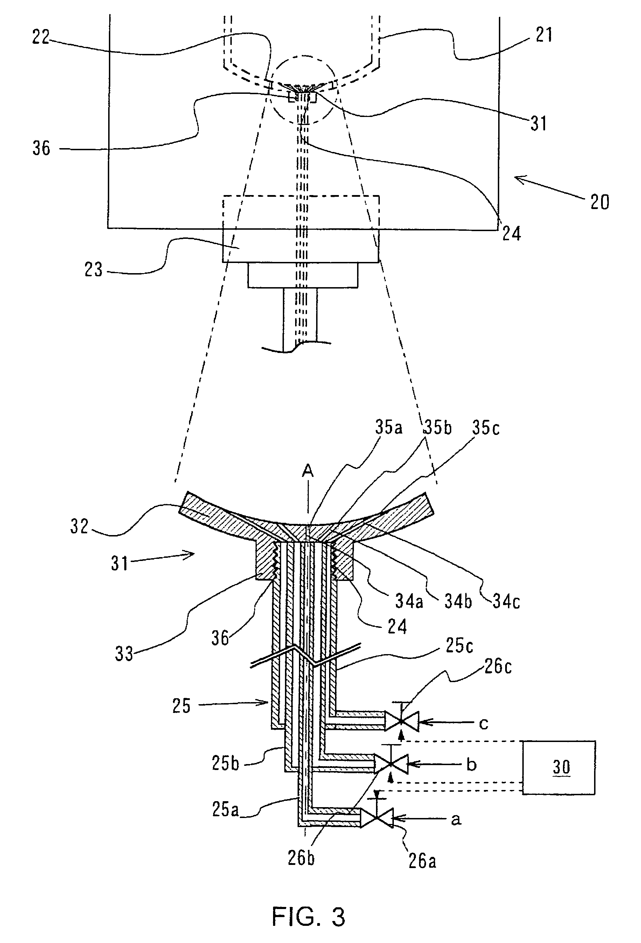

Fig. 3 shows an example wherein gas inlet pipes 25a, 25b and 25c are formed for gas inlet channels 34a, 34b and 34c respectively and each of the gas inlet pipes is adapted to independently adjust the feed gas pressure therein. A gas inlet nozzle 31 is fitted to a bottom 22 of a reaction vessel 21 constituting the fluidized bed of an apparatus 20 for manufacturing coated fuel particles for HTGRs in such a manner that the nozzle 31 constitutes a part of the centre region of the vessel bottom when it is fitted.

The gas inlet nozzle 31, in the same way as shown in Fig. 1, is provided with a round dish-shaped nozzle body 32 and a cylindrical gas inlet 33 which is disposed on the back side thereof and communicates with an end of a gas inlet pipe 25 extending from a gas feed system disposed on the outside of the apparatus. The dish-shaped nozzle body 32 fits into the vessel bottom 22 so that the centre axis A thereof is coincide with the centre axis of the cylindrical fluidized-bed reaction vessel 21. The nozzle body 32 has a concavely curved surface, which forms a continuous concavely curved surface with the vessel bottom surface when it is fitted into the vessel bottom.

Here, in the present example too, the gas inlet nozzle 31 is fitted to the vessel bottom 22 and has a cylindrical gas inlet 33 for connecting an end portion of a connecting pipe 23 which is connected to the gas inlet pipe 25 extending from a gas source disposed outside the apparatus 20. As the connecting mechanism between the gas inlet 33 and the connecting pipe 23, in the same way as shown in Fig. 1, it is possible to form a male screw portion 24 on the outer periphery of the end, on the side of the vessel, of the connecting pipe 23 on the one hand, and to form a female screw portion 36 which is screwed together with the male screw portion 24 of the connecting pipe 23 on the cylindrical inner periphery of the gas inlet 33 on the other hand, so that a hermetically secured connection is realized by screwing both the male and female screw portions together.

In this case, the gas inlet nozzle 31 can easily be detached from the vessel bottom 22 only by releasing the screwing of both the male and female screw portions and hence it is possible to change only the nozzle 31 simply and conveniently in the event of the clogging or the wear and damage of the gas inlet nozzle 31.

In the dish-shaped nozzle body 32, the nozzle openings 35a, 35b and 35c and gas inlet channels 34a, 34b and 34c communicating with the nozzle openings respectively are formed in the same way as the aforementioned embodiment shown in Fig. 1. The gas inlet pipe 25 is a triple pipe and a main feed gas is introduced through a pressure/ flow rate regulator 26a into a first gas inlet pipe 25a which is disposed on the centre axis A of the nozzle body. A second gas inlet pipe 25b is formed around the first gas inlet pipe 25a and an auxiliary feed gas b is introduced through another pressure/flow rate regulator 26b. A third gas inlet pipe 25c is formed around the second gas inlet pipe 25b and another auxiliary feed gas c is introduced from still another pressure/flow rate regulator 26c.

On the side of the gas inlet pipe 25 of the gas inlet channels 34a, 34b and 34c, each of the gas inlet channels communicates with one of the first, second and third gas inlet pipes of the triple pipe. That is, the first gas inlet pipe 25a communicates with the gas inlet channel 34a, the second gas inlet pipe 25b with the gas inlet channels 34b, and the third gas inlet pipe 25c with the gas inlet channels 34c, respectively. The pressure and the flow rate of each feed gases supplied from the gas inlet pipes are controlled by a controller 30 through each of the relevant pressure/flow rate regulators 26a, 26b and 26c.

With regard to the control of the gas pressure and the flow rate of each of the feed gases, a state of equilibrium among the feed gases are required, and therefore it is preferable to control each of the pressure/flow rate regulators 26a, 26b and 26c by an automatic control with the controller 30. That is, the controller 30 prescribes the control conditions on the pressure and the flow rate of each feed gas beforehand, monitors the pressure and the flow rate of each feed gas during actual operation, and carries out predetermined adjusting operations when the prescribed conditions are deviated.

For example, an auxiliary gas flow rate is set at 20 L/min as the initial flow rate beforehand, and when the flow rate is decreased to 10 L/min suddenly during actual operation, the set value of the flow rate for the auxiliary gas flow is temporarily increased to 40 L/min, and for the other gas inlet channels, the set values of the flow rates are temporarily decreased by about 10 to 20 L/min, thereby it is possible to concentrate the pressure on the nozzle opening which is nearly clogged and solve the problem.

Further, in order to improve the fluidity of the particles charged in the reaction vessel, for example, the control of repeating the operations of ejecting the main feed gas for 0.5 sec and immediately thereafter ejecting the auxiliary feed gas for 0.2 sec may preferably be set on the controller 30.

The nozzle openings 35c, which are allocated along the outermost circular zone C on the top surface of the nozzle body 32, open in a circular groove formed along the circular zone C to link the adjacent gas inlet channels 34c to each other on the same circular zone on the top surface of the nozzle 31. The core part of the nozzle body may be formed with a graphite shield block which is hermetically fitted into the peripheral part of the nozzle body, and in this case, the gas inlet channels and the nozzle openings as well as the circular groove may be formed in the graphite shield block of a precise structure having a sufficient durability as a gas ejecting nozzle core. The graphite shield block does not require sophisticated working and finishing of the gas inlet channels unlike a conventional nozzle body and hence it has also the advantage that the manufacturing cost can be reduced considerably.

In the present example, the nozzle opening 35a on the centre axis A is used as the main nozzle opening, and the nozzle openings in the circular groove on the outermost circular zone C and the nozzle openings on the circular zone B located on the inner side of the circular groove are used as auxiliary nozzle openings. In case the circular groove functions well, the auxiliary nozzle openings on the inner circular zone B may be omitted or the gas supply from the same may be stopped in normal state. Further, the main nozzle opening on the centre axis A may be configured so that a plurality of nozzle openings are arranged in the vicinity of the centre axis A in accordance with the diametrical size of the reaction vessel.

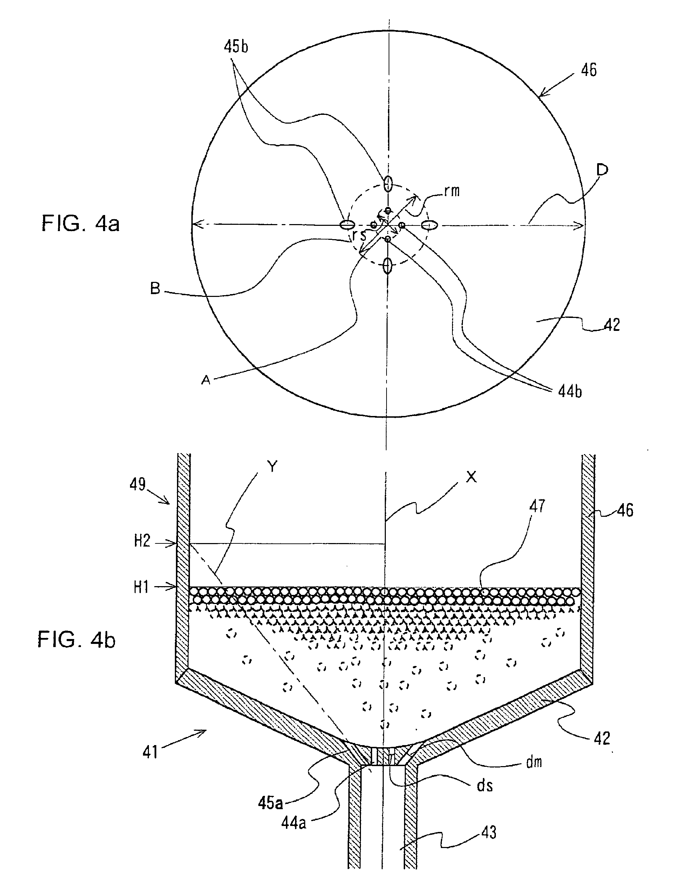

In another practical experience using a fluidized-bed reaction vessel equipped with a gas inlet Nozzle which satisfies the aforementioned expressions (1) to (3), a batch of fuel kernels are coated with four layers ranging from the aforementioned first to fourth coating layers as stated below. Now, Figs. 4a and 4b schematically show a partial configuration of the reaction vessel equipped with a gas inlet nozzle according to the present embodiment, where Fig. 4a is a plan view of the bottom of the reaction vessel which bottom is formed by a dish-shaped nozzle body and Fig. 4b a sectional side view of the bottom portion of the reaction vessel 49.

In this example, the gas inlet nozzle 41 comprises a round dish-shaped nozzle body 42 and a gas inlet 43 which is formed on the back side of the nozzle body and is communicated with a gas feed system (not shown in the figure) outside the apparatus. The dish-shaped nozzle body 42 is fixed to the bottom of the vessel 46 so that the centre axis X thereof is disposed coaxially to the reaction vessel 49, thereby forming a major part of the bottom of the reaction vessel 49.

In the dish-shaped nozzle body 42, a plurality of gas inlet channels 44a and 45a passing through the nozzle body are formed and radially branched from the gas inlet 43 toward the inner peripheral wall of the vessel. The gas inlet channels have their respective nozzle openings on the vessel bottom surface at the positions allocated along a first circular zone A and a second circular zone B respectively. Nozzle openings 44b on the first circular zone A and nozzle openings 45b on the second circular zone B are allocated at equally spaced intervals along the circular zones respectively, and the nozzle openings on an identical circular zone have an identical opening area and are communicated with the gas inlet channels having an identical sectional area which correspond to the identical opening area of the associated nozzle openings.

In the present example, the actual dimensions of the apparatus were chosen for the diameter rs of the first circular zone A closer to the centre axis X at 12 mm, for the diameter ds of the first inlet channels 44a at 3 mm, for the number Ns of the first nozzle openings 44b at 4, for the diameter rm of the second circular zone B closer to the outer circumference at 40 mm, for the diameter dm of the second inlet channels 45a at 5 mm, for the number Nm of the second nozzle openings 45b at 4, and for the inner diameter D of the reaction vessel 49 at 200 mm.

In this case, the value of rm/D is 0.200 which satisfies the expression (1) $0.15 \leq rm/D \leq 0.22$, the value of rs/D is 0.06 which satisfies the expression (2) $rs/D \leq 0\text{-}08$, and the value of $Ns \times ds^2/(Ns \times ds^2 + Nm \times dm^2)$ was 0.265 which satisfies the expression (3) $Ns * ds^2/(Ns \times ds^2 + Nm \times dm^2) < 1/3$. Thus all the conditions stipulated by the expressions (1) to (3) were satisfied.

Further, in the present example, the angle "alpha" of the second inlet channels 45a to the centre axis X was set at 30 degrees, the height H1 of the upper surface of the charged fuel kernels 47 when an amount thereof corresponding to one batch amount was charged in the reaction vessel 49 was set at about 80 mm, and the height H2 of the point where the extension line Y of the centre axis of each axis of the second inlet channels 45a intersected with the inner wall 46 of the reaction vessel was set at 100 mm. Those set values satisfied the condition stipulated as "the height H2 of a point where the extension of the centre axis of a second inlet channel intersects with the inner wall of a reaction vessel is not lower than the height H1 of the upper surface of fuel kernels charged in the reaction vessel," and the condition was also satisfied in the processes of coating the fuel kernels with all the four layers.

In the reaction vessel configured as stated above, uranium dioxide fuel kernels 0.6 mm in average diameter in the amount of 3.8 kg of one batch amount were subjected to the processes of forming the first to fourth coating layers thereon and coated fuel particles of the target outer diameter 0.92 mm were manufactured.

Firstly, fuel kernels 47 in the amount corresponding to one batch amount were charged in a reaction vessel 49 and a first coating layer consisting of a low-density carbon layer was formed by supplying acetylene gas into the reaction vessel 49 through the nozzle 41 at the temperature in the vessel of about 1,400 °C, and thereafter a second coating layer consisting of a high-density pyrolytic carbon layer was formed by supplying propylene at about 1,400 °C. Successively, a third coating layer consisting of an SiC layer was formed by supplying methyltrichlorosilane at about 1,600 °C, and finally a fourth coating layer consisting of a high-density pyrolytic carbon layer was formed by supplying propylene at about 1,400 °C.

The average diameter of the fourfold layered fuel particles obtained was 0.93 mm and the thicknesses of the coating layers were 0.06 mm in the first coating layer, 0.03 mm in the second coating layer, 0.03 mm in the third coating layer, and 0.045 mm in the fourth coating layer, respectively, and thus all of the first to fourth coating layers were formed with very uniform thicknesses. This is because the coating material mixed gas could be supplied into the reaction vessel 49 stably and uniformly by designing the first inlet channels 44a, the nozzle openings 44b, the second inlet channels 45a, and the nozzle openings 45b so as to satisfy the aforementioned expressions (1) to (3) in the nozzle 41 of the present example.

(B) Airtight Housing Door (Improvement of maintainability):

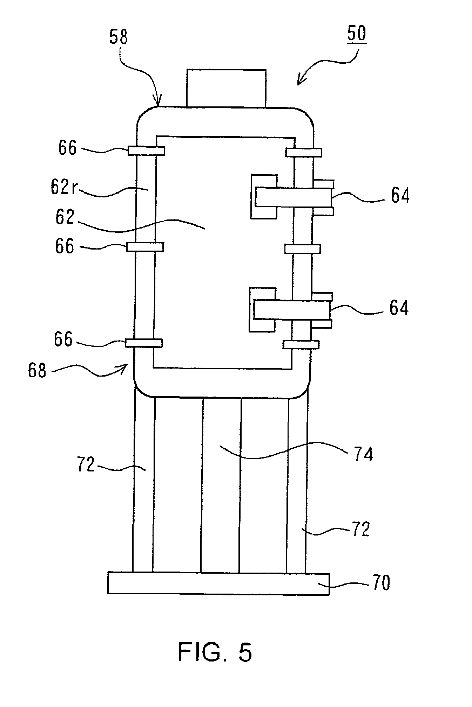

For a fluidized-bed reaction vessel equipped with a gas inlet nozzle of a type as shown in any one of Figs. 1 to 4, a preferable structure of an airtight housing in which the reaction vessel is built will now be described in detail. Figs. 5 to 7 show an example of an apparatus 50 for manufacturing coated fuel particles for HTGRs according to the present invention. The apparatus 50 comprises a reaction vessel 52 for reacting fuel kernels with a reaction gas to form a coating layer on the surfaces of the fuel kernels and an airtight housing (outer shell) 58 in which the vessel 52, a plurality of bar heaters 54 and a cylindrical insulating members 56 are disposed in such a manner that the heaters surround the outer periphery of the reaction vessel 52 and the insulating member surrounds the yet outer periphery of the heaters.

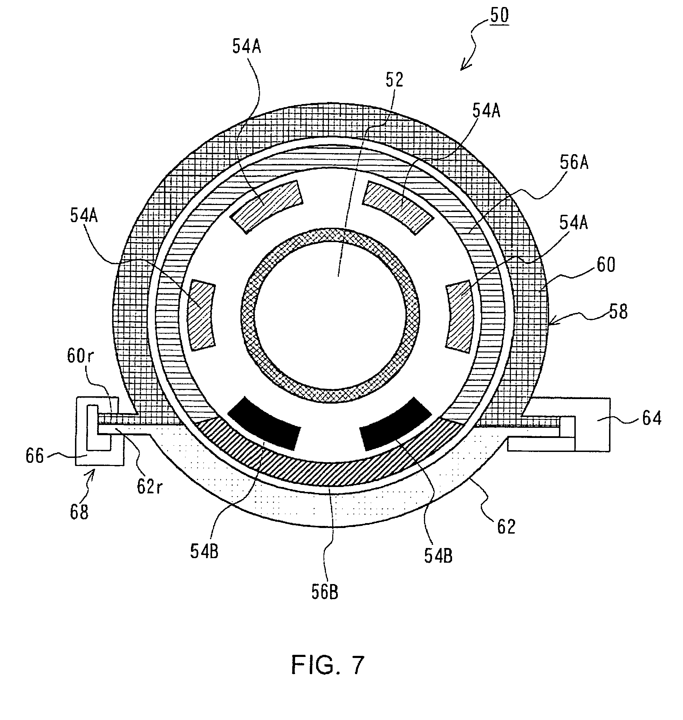

The airtight housing 58 comprises a housing body 60 a part of which peripheral wall is cut out and forms an opening 61 and a front door 62 attached to the housing body 60 to open and close the opening 61 (refer to Fig. 7). The heaters 54 and the insulating member 56 are separated into two segmental parts to be separately attached to the housing body 60 and the front door 62 as denoted with the reference numerals 54A and 56A (those to be attached to the housing body) and 54B and 56B (those to be attached to the front door). In the closed position of the front door 62, the segmental insulating member 56A on the housing body 60 and the segmental insulating member 56B on the front door 62 are configured so as to tightly contact with each other and hence the thermal insulating properties of the fluidized bed reaction vessel 52 will not be deteriorated with the clearance between the housing body 60 and the front door 62.

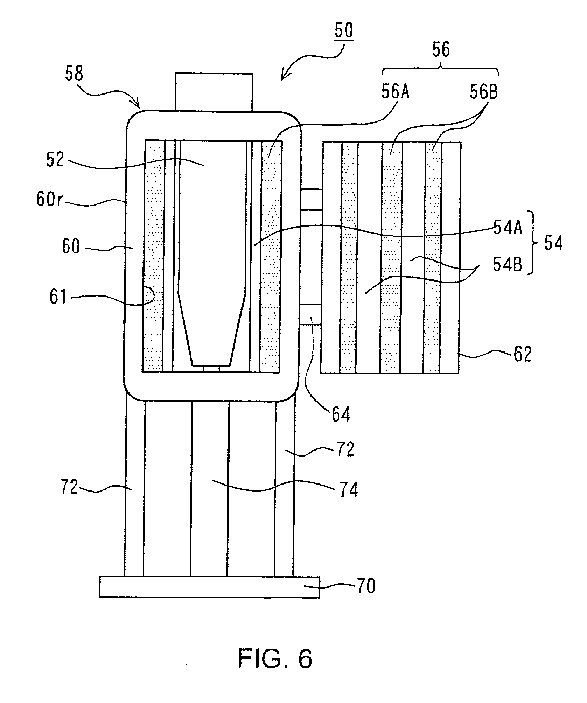

In the example shown in Figs. 5 and 6, the front door 62 is attached to the edge of the opening 61 of the housing body 60 with hinges 64 in an openable and closable manner and the maximum open angle may be 180 degrees or over as shown in Fig. 6. The maximum open angle may properly be selected in consideration of the working space and the operability.

The front door 62 is provided with a door lock mechanism 68 including a plurality of clamps 66 to keep the door 62 in the closed position on the opening 61. The clamps 66 may have an appropriate shape so as to straddle the both edges of the housing body 60 and of the front door 62 and clamp these edges to tightly contact with each other. It will be understood from Fig. 7 that the clamps 66 hold tight both the peripheral rib 60r of the housing body 60 and the peripheral rib 62r of the front door 62 to forum an entire tight seal in between.

The airtight housing 58 is supported by a base 70 via leg members 72 and the reaction vessel 52 is equipped with a gas feed pipe 74 disposed between the base 70 and the housing body 60 and connected to a gas feed system not shown in the figures, and the gas feed pipe 74 is communicated with the reaction vessel 52.

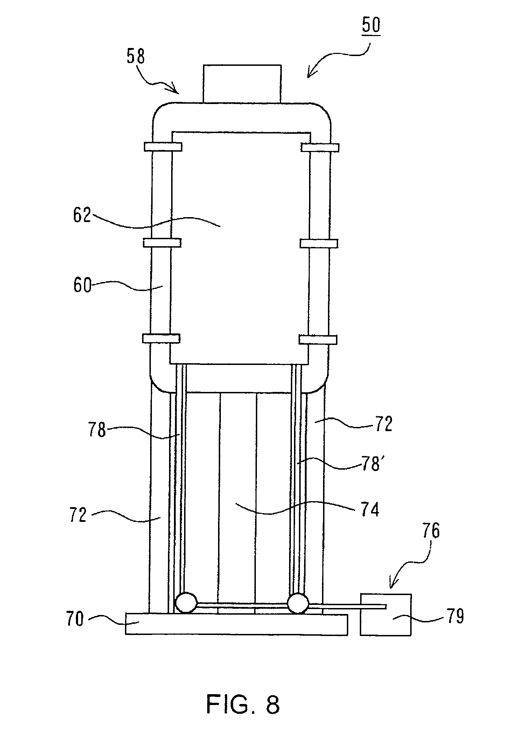

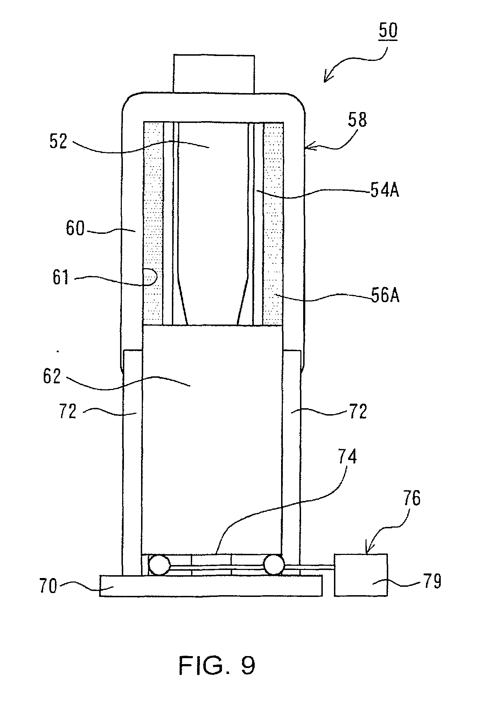

A modified example of the apparatus 50 for manufacturing coated fuel particles for HTGRs will now be described with reference to Figs. 8 and 9. The modified embodiment of the apparatus 50 is the same as the embodiment shown in Figs. 5 to 7 except that, in the modified embodiment, the front door 62 is not a hinged single door but is attached to the housing body 60 in the manner of sliding vertically to open and close the opening 61. The same reference numerals as those used in Figs. 5 to 7 are used for the parts corresponding to those shown in Figs. 5 to 7.

The apparatus shown in Figs. 8 and 9 comprises a slide manipulator 76 to open and close the front door 62. The slide manipulator 76 includes a pair of ball screws 78 and 78' for actuating and guiding the front door 62 upward and downward and a rotary drive 79 such as a step motor to rotate the ball screws 78 and 78.' When the rotary drive 79 is activated, the pair of ball screws 78 and 78' are rotated to forward or reverse direction to move the front door 62 between the ascended position where the front door 62 is closed as shown in Fig. 8 and the descended position where the front door 62 is open as shown in Fig. 9.

The apparatus 50 according to the modified example makes it possible to open the front door 62, remove the reaction vessel 52 from the housing body 60, and scavenge the inner chamber of the reaction vessel 52. Thereafter, the reaction vessel 52 is brought back into the housing body 60 and the front door 62 is closed, and then the apparatus is restored to the status quo ante. When the front door is closed and tightly clamped to form an airtight housing chamber, the segmental insulating member 56A disposed in the housing body 60 and the segmental insulating member 56B mounted on the inner surface of the front door 62 tightly touch with each other to form an integral cylinder structure of the shielding members within the airtight housing chamber surrounded by the housing body 60 and the front door 62 which is tightly clamped to the housing body.

After the front door is closed and tightly clamped to the housing body, a batch of fuel kernels is charged into the reaction vessel 52 through a charging hole of the vessel at the top of the apparatus, then the charging hole is closed and the airtight housing chamber is reestablished. Now the apparatus is ready to start a sequential process for forming the aforementioned first to fourth coating layers while several kinds of coating material mixed gases are sequentially supplied into the reaction vessel 52 through the gas feed pipe 74 and the mixed gases are reacted with the fuel kernels in the fluidized-bed formed within the reaction vessel 52.

In a practical example of the apparatus 50 having a configuration shown in Figs. 5 to 7, the airtight housing 58 had an outer diameter of about 700 mm and a height of about 2,200 mm, and the graphite-made reaction vessel 52 had an inner diameter of about 200 mm and a height of about 1,000 mm. Uranium dioxide fuel kernels 0.6 mm in average diameter of a batch amount of about 3.8 kg were charged into the reaction vessel 52, and a low-density carbon coating as the first coating layer was formed with an acetylene $C_2H_2$ gas flow (reaction gas for forming the first coating layer) supplied from the gas feed pipe 74 at a temperature of about 1,400 °C, successively a high-density carbon coating as the second coating layer was formed with a propylene $C_3H_6$ gas flow (reaction gas for forming the second coating layer) at a temperature of about 1,400 °C, a silicon carbide coating as the third coating layer was formed with a methyltrichlorosilane $CH_3SiCl_3$ gas flow (reaction gas for forming of the third coating layer) at a temperature of about 1,600 °C, and finally a high-density carbon coating as the fourth coating layer was formed with a propylene $C_3H_6$ gas flow (reaction gas for forming the fourth coating layer) at a temperature of about 1,400 °C. The average diameter of the coated fuel particles thus obtained was 0.93 mm, and the thicknesses of the coating layers were 0.06 mm in the first coating layer, 0.03 mm in the second coating layer, 0.03 mm in the third coating layer, and 0.045 mm in the fourth coating layer.

The reaction vessel 52 can be attached and detached by opening the front door 62, and hence the attaching and detaching works thereof are easy, and therefore extraneous matter, such as graphite powder, soot and other grimes, deposited on the interior of the reaction vessel can easily be removed with a vacuum or the like.

(C) Segment-type Reaction Vessel (improvement of maintainability) :

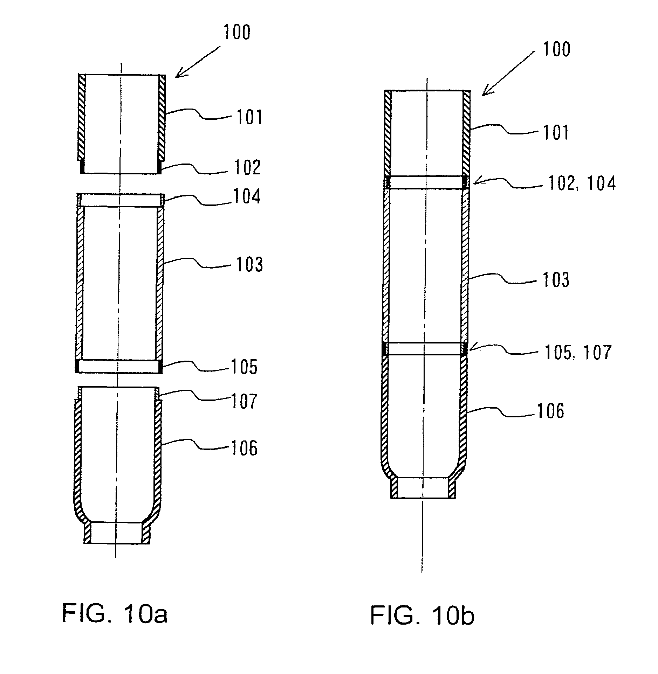

For a fluidized-bed reaction vessel equipped with a gas inlet nozzle of a type as shown in any one of Figs. 1 to 4, a preferable structure of the reaction vessel will now be described in detail. Figs. 10a and 10b show an example of the structure of the reaction vessel comprising a set of cylindrical members mutually connected in the form of three detachable stages to form a single cylindrical vessel structure. Fig. 10a is a sectional side view in which a plurality of cylindrical members are separated and Fig. 10b a sectional side view in which the cylindrical members are connected into a single cylindrical vessel structure.

In this example, the reaction vessel 100 is composed of three cylindrical members including a first cylindrical member 101, a second cylindrical member 103 and a third cylindrical member 306. As for connection means for securing a tight seal between the cylindrical members 101, 103 and 106, male/female screw engagement is tightly formed at each of the mutual connection portions between the adjacent cylindrical members.

That is, as shown in Fig. 10a, the first cylindrical member 101 which constitutes the uppermost part of the reaction vessel 100 has a male screw portion 102 formed on the outer periphery of the bottom end thereof, and the second cylindrical member 103 which constitutes an intermediate part of the vessel 100 has a female screw portion 104 on the inner periphery of the top end thereof so that the male and female screw portions 102 and 104 are to be tightly screwed with each other. The second cylindrical member 103 has another female screw portion 105 formed on the inner periphery of the bottom end thereof, and the third cylindrical member 106 which constitutes the lowermost part of the vessel 100 has a male screw portion 107 formed on the outer periphery of the top end thereof so that the female and male screw portions 105 and 107 are to be tightly screwed with each other.

Consequently, with the mutual tight connection formed between each of the male screw portions (102, 107) and the female screw portions (104, 105) correspondingly, the first, second and third cylindrical members 101, 103 and 106 are tightly connected to form the reaction vessel 100 having a single cylindrical vessel structure as shown in Fig. 10b.

In a practical experience, the cylindrical members were connected sequentially in the order of the third cylindrical member 106, the second cylindrical member 103 and then the first cylindrical member 101 to build a fluidized-bed reaction vessel 100 of about 200 mm diameter and about 1,000 mm height in an airtight cylindrical housing of an apparatus for manufacturing coated fuel particles. On the bottom of the reaction vessel 100, a gas inlet nozzle was mounted to supply a coating material mixed gas into the vessel 100, and the vessel was surrounded with heaters for heating the internal reaction chamber of the vessel to a predetermined temperature necessary for the thermal decomposition of the coating material contained in the mixed gas. Using the apparatus of this configuration, uranium dioxide fuel kernels of a batch amount were coated with a fourfold coating layer through the process as stated below.

Firstly, uranium dioxide fuel kernels 0.6 mm in average diameter of a batch amount of about 3.8 kg were charged into the reaction vessel 100, and then a first coating layer consisting of low-density carbon was formed with an acetylene ($C_2H_2$) gas flow at about 1,400 °C. Successively, a second coating layer consisting of high-density pyrolytic carbon was formed with a propylene ($C_3H_6$) gas flow at about 1,450 °C. Thereafter, a third coating layer consisting of an SiC was formed with a methyltrichlorosilane ($CH_3SiCl_3$) gas flow at about 1,650 °C. Then finally, a fourth coating layer consisting of high-density pyrolytic carbon was formed with a propylene ($C_3H_6$) gas flow at about 1,400 °C.

In these successive coating processes, there was no outgassing from the mutual connection portions between the respective cylindrical members of the reaction vessel 100 and the series of the processes proceeded well. Then the average diameter of the obtained coated fuel particles was 0.93 mm, and the thicknesses of the coating layers were 0.06 mm in the first coating layer, 0.03 mm in the second coating layer, 0.03 mm in the third coating layer, and 0.045 mm in the fourth coating layer.

After the finish of the successive coating processes, the reaction vessel 100 was dismounted simply in a short period of time while releasing the screw portions of the mutual connections and separating the cylindrical members 101, 103 106, adherence of coated fuel particles to the mutual connection portions of the male screws 102 and 107 and the female screws 104 and 105 was not occurred, cleaning of the cylindrical members was easily carried out, and the remounting of the reaction vessel to the apparatus could also be carried out simply and conveniently while the cylindrical members were assembled in order.

Although the male/female screw connection is used In the above-mentioned embodiment, the mutual connection between the cylindrical members may be achieved with any other connection mechanism as long as it plays a detachable tight seal connection between the cylindrical members, and the present invention is not particularly limited thereto, however, a connection mechanism which is adapted to easy assemble/disassemble works is preferable.

(D) Isolation of Reaction Vessel (Prevention of wear/damage of graphite):

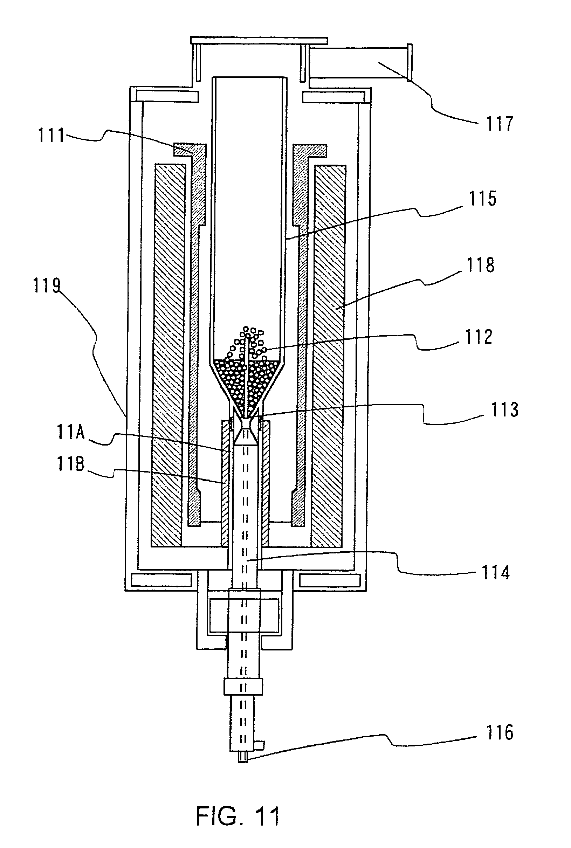

For a fluidized-bed reaction vessel equipped with a gas inlet nozzle of a type as shown in any one of Figs. 1 to 4, a preferable structure of the reaction vessel and the associating housing will now be described in detail. Fig. 11 shows an exemplary configuration of an apparatus for manufacturing coated fuel particles for HTGRs according to the present invention. As shown in Fig. 11, the fluidized-bed reaction apparatus comprises a reaction vessel 115 for forming a coating layer on the surface of uranium dioxide fuel kernels 112 which are charged in the vessel through a charging hole (not shown) formed at the top of the vessel, the vessel being equipped with a gas inlet nozzle 113 for introducing a coating material mixed gas of a coating gas and a fluidizing gas supplied from a gas source (not shown) through a gas inlet 116 and a gas inlet pipe 114, a graphite-made cylindrical heater 111 mounted around the outer periphery of the reaction vessel 115 to heat the interior of the vessel, a cylindrical heat insulating member 118 which is also made of graphite and disposed to surround the outer circumference of the mounted heater 111, and an airtight cylindrical housing 119 in which the vessel, the heater and the insulating member are housed.

In the present example, disposed beneath the reaction vessel 115 is a carbon cylinder 11A, the top end of which is tightly connected by a screw engagement to an integral cylindrical portion extended from the bottom of the vessel 115. The outer periphery of the carbon cylinder 11A is surrounded with a graphite-made heat insulating cylinder 11B for the purpose of preventing the gas inlet pipe 114, which may generally be made of metal, from melting at a high temperature environment in the reactor. In a practical example, the dimensions of the housing 119 was about 700 mm in diameter and about 2,200 mm in height, and the dimensions of the reaction vessel was about 200 mm in diameter and about 1,000 mm in height.

Using the apparatus of this configuration, uranium dioxide fuel kernels 0.6 mm in average diameter of a batch amount of 3.8 kg were charged into the reaction vessel and a first coating layer consisting of a low-density carbon layer was formed with an acetylene ($C_2H_2$) gas flow at about 1,400 °C. Successively, a second coating layer consisting of high-density pyrolytic carbon was formed with a propylene (C3H$_6$) gas flow at about 1,400 °C. Thereafter, a third coating layer consisting of an SiC was formed with a methyltrichlorosilane ($CH_3SiCl_3$) gas flow at about 1,600 °C. Then finally, a fourth coating layer consisting of high-density pyrolytic carbon was formed with a propylene ($C_3H_6$) gas flow at about 1,400 °C.

As a result of the successive coating processes, the evidence of deterioration caused by the hydrocarbon generated by the reaction on the heater 111 and the insulating member 118 with hydrogen was not found, the average diameter of the obtained coated fuel particles was 0.93 mm, and the thicknesses of the layers were 0.06 mm in the first coating layer, 0.03 mm in the second coating layer, 0.03 mm in the third coating layer, and 0.045 mm in the fourth coating layer, and were of very uniform.

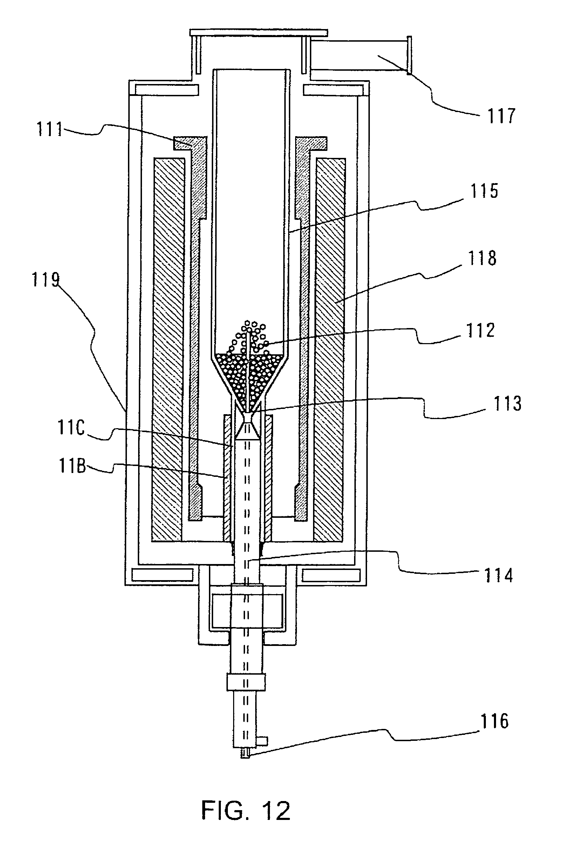

Fig. 12 shows an exemplary configuration of another example of an apparatus for manufacturing coated fuel particles for HTGRs according to the present invention. In the present embodiment, an integral cylindrical portion 11C is extended lengthwise from the bottom of the vessel 115 to the bottom of the airtight housing 119 as an alternative design to the carbon cylinder 11A shown in Fig. 11. The lower end of the cylindrical portion 11C is tightly connected by a screw engagement to the bottom of the airtight cylindrical housing 119, and other configurations are about the same as those shown in Fig. 11.

Also in this example, since hydrogen gas as a fluidizing gas does not leak out from a gap between the gas inlet pipe 114 and the gas inlet nozzle 113 of the reaction vessel 115 and does not flow into the space in which the heater 111 and the insulating member 118 are disposed when the third coating layer is formed, it is possible to prevent graphite which is a typical constituent material of the heater 111 and of the insulating member 118 from reacting with hydrogen and suffering wear and damage.

Since the heater 111 and the insulating member 118 do not suffer wear and damage, even in successive coating processes, the temperature distribution in the reactor vessel does not vary and is stable and hence it is possible to stabilize the quality of the coating layers which play a very important role in the function of confining the fissionable materials in fuel for HTGRs.

(E) Inert Gas Supply to Surroundings of Reaction Vessel:

(Prevention of wear and damage of graphite)

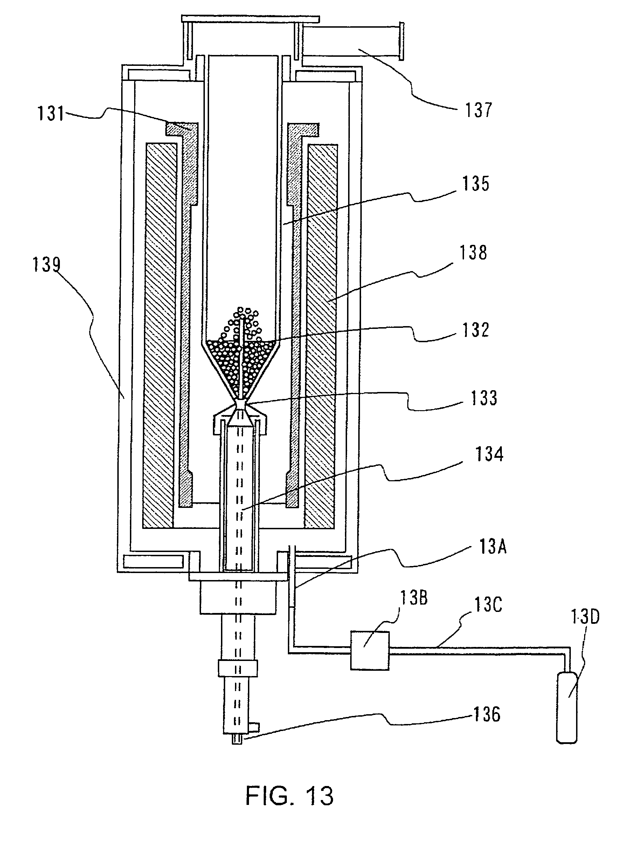

For a fluidized-bed reaction vessel equipped with a gas inlet nozzle of a type as shown in any one of Figs. 1 to 4, another preferable structure of the reaction vessel and the associating housing will now be described in detail. Fig. 13 shows an exemplary configuration of a still another example of an apparatus for manufacturing coated fuel particles for HTGRs according to the present invention. As shown in Fig. 13, the fluidized-bed reaction apparatus comprises a reaction vessel 135 for forming a coating layer on the surface of uranium dioxide fuel kernels 132 which are charged in the vessel through a charging hole formed at the top of the vessel, the vessel being equipped with a gas inlet nozzle 133 for introducing a coating material mixed gas of a coating gas and a fluidizing gas supplied from a gas source (not shown) through a gas inlet 136 and a gas inlet pipe 134, a graphite-made cylindrical heater 131 mounted around the outer periphery of the reaction vessel 135 to heat the interior of the vessel, a cylindrical heat insulating member 138 which is also made of graphite and disposed to surround the outer circumference of the mounted heater 131, and an airtight cylindrical housing 139 in which the vessel, the heater and the insulating member are housed. At the top of the housing, a waste gas outlet 137 is equipped for discharging the used coating material mixed gas to a gas treatment apparatus outside the reactor, and at the lowermost portion of the apparatus, the gas inlet 136 is also used for taking out the coated fuel particles.

In a practical example, the dimensions of the apparatus were about 700 mm in diameter and about 2,200 mm in height, and the dimensions of the reaction vessel were about 200 mm in diameter and about 1,000 mm in height.

Using the apparatus of the above configuration, uranium dioxide fuel kernels 0.6 mm in average diameter of a batch amount of 3 kg were charged into the reaction vessel 135 and a first coating layer consisting of a low-density carbon layer was formed with an acetylene ($C_2H_2$) gas flow at about 1,400 °C. Successively, a second coating layer consisting of high-density pyrolytic carbon was formed with a propylene ($C_3H_6$) gas flow at about 1,400 °C. Thereafter, a third coating layer consisting of an SiC was formed with a methyltrichlorosilane ($CH_3SiCl_3$) gas flow at about 1,600 °C. Then finally, a fourth coating layer consisting of high-density pyrolytic carbon was formed with a propylene ($C_3H_6$) gas flow at about 1,400 °C.

When the first to fourth coating layers were formed, a space between the cylindrical housing 139 and the reaction vessel 135 where the heater 131 and the insulating member 138 are disposed was pressurized with an argon gas through an inert gas inlet pipe 13A. Thereby, even when the coating processes were successively carried out, deterioration on the heater 131 and the insulating member 138 caused by hydrocarbon was not found and coated fuel particles having uniform quality were obtained. Here, the inert gas inlet pipe 13A was connected to an argon gas bottle 13D through a connecting pipe 13C in which a controller 13B was intercalated for controlling the inner pressure of the airtight housing 139 to a predetermined pressure level. The controller 13B was designed so as to control the inner pressure to a predetermined pressure value for each of the successive coating processes for the first to fourth coating layers respectively.

With regard to the working pressure in the reaction vessel at the respective coating processes, the working pressure when the third coating layer was formed was the highest and hence the inner pressure of the housing was controlled at a set value of 0.2 MPa (gage pressure) which was somewhat higher than the working pressure in the reaction vessel for the coating process of the third coating layer. Here, the set value depends on the coating conditions of the third coating layer such as a flow rate of the coating material mixed gas and the reaction temperature, and hence it is only necessary that the inner pressure of the housing or of the surrounding space outside the reaction vessel is equal to or higher than the working pressure inside the reaction vessel in accordance with the coating conditions of the respective coating processes. Further, although the inner pressure of the housing was controlled to the constant level of 0.2 MPa (gage pressure) during all the coating processes in the present embodiment, the inner pressure may be controlled at different pressure levels for respective periods of the successive coating processes.

As stated above, while the SiC layer is formed, it is possible to prevent hydrogen gas contained in the coating material mixed gas from leaking out from a gap between the gas inlet nozzle 133 and the reaction vessel 135 and also prevent the graphite which is a typical constituent material of the heater 131 and the insulating member 138 from reacting with hydrogen and suffering wear and damage. Since the wear and damage of the heater 131 and the insulating member 138 are avoided, even in the case of successive coating processes of the fuel particles, the temperature distribution in the reactor does not vary and is stabilized. As a consequence, it is possible to stabilize the quality of the coating layers, which play a very important role in the function of confining the fissionable materials in fuel for HTGRs.

(F) Inert Gas Supply to Surroundings of Reaction Vessel:

(Prevention of wear and damage of graphite)

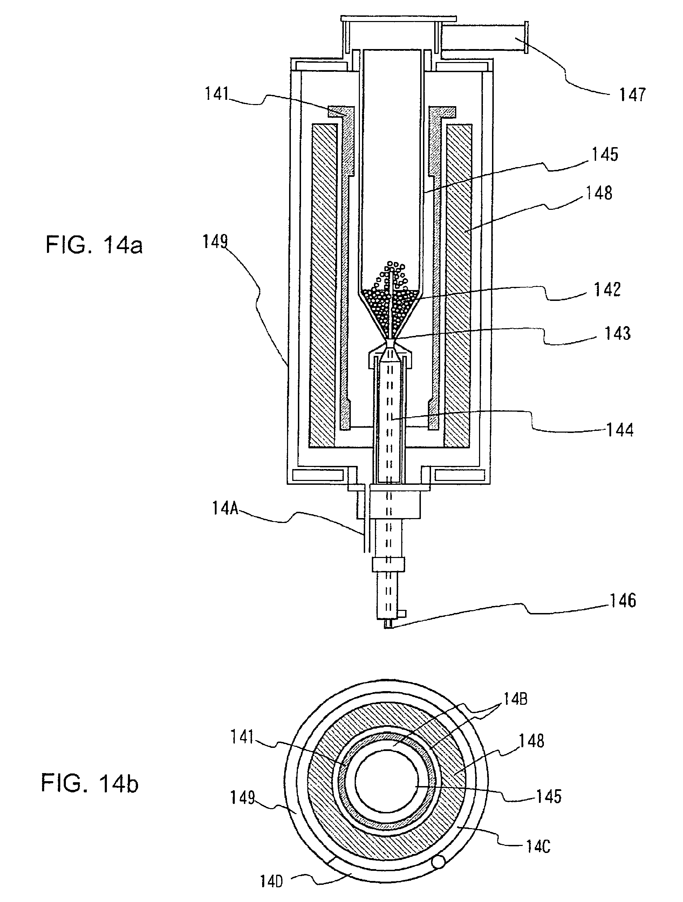

For a fluid ized-bed reaction vessel equipped with a gas inlet nozzle of a type as shown in any one of Figs. 1 to 4, still another preferable structure of the reaction vessel and the associating housing will now be described in detail. Figs. 14a and 14b show an exemplary configuration of a still another example of an apparatus for manufacturing coated fuel particles for HTGRs according to the present invention. As shown in Fig. 14a, the fluidized-bed reaction apparatus comprises a reaction vessel 145 for forming a coating layer on the surface of uranium dioxide fuel kernels 142 which are charged in the vessel through a charging hole formed at the top of the vessel, the vessel being equipped with a gas inlet nozzle 143 for introducing a coating material mixed gas of a coating gas and a fluidizing gas supplied from a gas source (not shown) through a gas inlet 146 and a gas inlet pipe 144, a graphite-made cylindrical heater 141 mounted around the outer periphery of the reaction vessel 145 to heat the interior of the vessel, a cylindrical heat insulating member 148 which is also made of graphite and disposed to surround the outer circumference of the mounted heater 141, and an airtight housing 149 in which the vessel, the heater and the insulating member are housed.

According to the invention, the reaction vessel 145, the insulating member 148, and the airtight housing 149 are formed into a cylindrical shape respectively and are disposed concentrically in a cross sectional view within the inner space of the housing to form an outer flow channel 14C between the insulating member 148 and the airtight housing 149 with a clearance having a uniform width all around the circumference thereof and two inner flow channels 14B, 14B between the insulating member 148 and the reaction vessel 145 in such a manner that the cylindrical heater 141 is disposed in between these two inner flow channels with respective clearances each having a uniform width all around the circumference thereof. The housing is provided with a sweep gas feed port 14A at the bottom thereof in order to feed a sweep gas into the inner space where the heater 141 and the insulating member 148 are disposed. In a practical embodiment, the dimensions of the airtight housing 149 were about 700 mm in diameter and about 2,200 mm in height, and the dimensions of the reaction vessel 145 were about 200 mm in diameter and about 1,000 mm in height. Although the heater 141 of a cylindrical shape was used in the present embodiment, a plurality of bar heaters may be arranged around the vessel in substitution for the cylindrical heater and in the case, the bar heaters are to be allocated at equal intervals circumferentially along the inner flow channels 14B.

Using the apparatus of the above configuration, uranium dioxide fuel kernels 0.6 mm in average diameter of a batch amount of 3 kg were charged into the reaction vessel and a first coating layer consisting of a low-density carbon layer was formed with an acetylene ($C_2H_2$) gas flow at about 1,400 °C. Successively, a second coating layer consisting of high-density pyrolytic carbon was formed with a propylene ($C_3H_6$) gas flow at about 1,400 °C. Thereafter, a third coating layer consisting of an SiC was formed with a methyltrichlorosilane ($CH_3SiCl_3$) gas flow at about 1,600 °C. Then finally, a fourth coating layer consisting of high-density pyrolytic carbon was formed with a propylene ($C_3H_6$) gas flow at about 1,400 °C.

When the first to fourth coating layers were formed, a nitrogen sweep gas was supplied from the sweep gas feed port 14 into the inner space between the airtight housing 149 and the reaction vessel 145 at the flow rate of 50 L/min. The nitrogen sweep gas as well as the coating material mixed gas which was leaked out from a gap between the gas inlet nozzle 143 and the reaction vessel 145 were discharged to the outside the reactor through a waste gas outlet 147 mounted on the top of the apparatus.

On the peripheral wall of the airtight housing 149, a door 14D configured so as to constitute a part of the cylindrical wall of the airtight housing is mounted as shown in Fig. 14b. Consequently, the sweep gas is uniformly introduced all around the outer flow channel 14C and hence it is possible to prevent graphite which is a typical constituent material of the heater and the insulating member from locally reacting with hydrogen and locally suffering wear and damage.

As stated above, even when hydrogen contained in the coating material mixed gas as the fluidizing gas leaks out from the gap between the gas inlet nozzle 143 and the reaction vessel 145 during the SiC layer is formed, the hydrogen containing gas is evacuated outside the apparatus by the sweep gas flow and hence it is possible to prevent graphite which is a constituent material of the heater 141 and the insulating member 148 from reacting with hydrogen and suffering wear and damage.

Also, since the wear and damage of the heater 141 and the insulating member 148 are avoided, even in the case of successive coating processes of the fuel particles, the temperature distribution in the reactor does not vary and is stabilized and hence it is possible to stabilize the quality of the coating layers which play a very important role in the function of confining the fissionable materials in fuel for HTGRs.

(G) Suction from Surroundings of Reaction Vessel:

(Prevention of wear and damage of graphite)

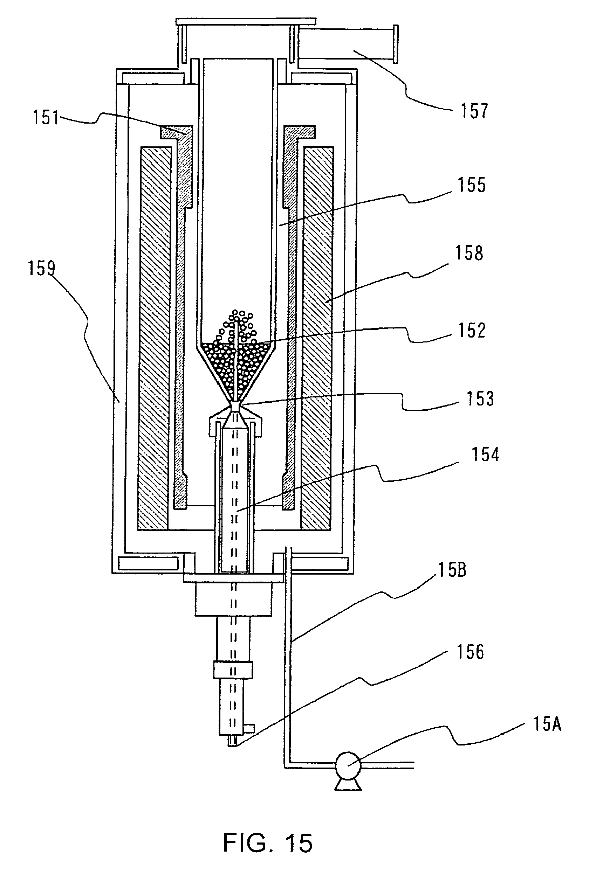

For a fluidized-bed reaction vessel equipped with a gas inlet nozzle of a type as shown in any one of Figs. 1 to 4, still another preferable structure of the reaction vessel and the associating housing will now be described in detail. Fig. 15 shows an exemplary configuration of still another example of an apparatus for manufacturing coated fuel particles for HTGRs according to the present invention. As shown in Fig. 15, the fluidized-bed reaction apparatus comprises a reaction vessel 155 for forming a coating layer on the surface of uranium dioxide fuel kernels 152 which are charged in the vessel through a charging hole formed at the top of the vessel, the vessel being equipped with a gas inlet nozzle 153 for introducing a coating material mixed gas of a coating gas and a fluidizing gas supplied from a gas source (not shown) through a gas inlet 156 and a gas inlet pipe 154, a graphite-made cylindrical heater 151 mounted around the outer periphery of the reaction vessel 155 to heat the interior of the vessel, a cylindrical heat insulating member 158 which is also made of graphite and disposed to surround the outer circumference of the mounted heater 151, and an airtight housing 159 in which the vessel, the heater and the insulating member are housed.

According to the invention, the apparatus comprises the housing 159, the insulating member 158, the heater 151, and the reaction vessel 155 in the order from outside. The apparatus further comprises a suction pipe 15B communicating with the inner space of the housing at the bottom thereof in order to forcibly discharge a gas from the inner space. In a practical embodiment, the dimensions of the housing 159 were about 700 mm in diameter and about 2,200 mm in height, and the dimensions of the reaction vessel 155 were about 200 mm in diameter and about 1,000 mm in height. Although the heater 151 of a cylindrical shape was used in the present embodiment, a plurality of bar heaters may be arranged around the vessel in substitution for the cylindrical heater and in the case, the bar heaters are to be allocated at equal intervals around the outer periphery of the vessel 155.

Using the apparatus of the above configuration, uranium dioxide fuel kernels 0.6 mm in average diameter of a batch amount of about 3 kg were charged into the reaction vessel and a first coating layer consisting of a low-density carbon layer was formed with an acetylene ($C_2H_2$) gas flow at about 1,400 °C. Successively, a second coating layer consisting of high-density pyrolytic carbon was formed with a propylene ($C_3H_6$) gas flow at about 1,400 °C. Thereafter, a third coating layer consisting of an SiC was formed with a methyltrichlorosilane ($CH_3SiCl_3$) gas flow at about 1,600 °C. Then finally, a fourth coating layer consisting of high-density pyrolytic carbon was formed with a propylene ($C_3H_6$) gas flow at about 1,400 °C.

When the first to fourth coating layers were formed, the inner space between the housing 159 and the reaction vessel 155 where the heater 151 and the insulating member 158 are mounted was depressurised with a suction pump 15A of a low-vacuum pump type such as a rotary pump, a mechanical booster pump or the like, which was connected to the suction pipe 15B. Thereby, even when the coating processes were successively carried out, deterioration on the heater 151 and the insulating member 158 caused by hydrocarbon was not found and coated fuel particles having uniform quality were obtained.

In the coating processes for the first, second and forth coating layers, a vacuum pump of explosion-proof specification may preferably used for the suction pump 14A since the coating material mixed gas will have a flammable gas composition.

According to the invention, suction from the housing inner space around the fluidized-bed reaction vessel is applied by a suction pump during the process, and any gas leaked out from a gap between the gas inlet nozzle 153 and the reaction vessel 155 is forcibly discharged to the exterior of the housing in which the heater and the insulating member are mounted. Thereby, even when hydrogen contained in the coating material mixed gas as the fluidizing gas leaks out from the gap between the gas inlet nozzle 153 and the reaction vessel 155 during the SiC layer is formed, the hydrogen containing gas is evacuated outside the housing 159 with the suction pump 15A and hence it is possible to prevent graphite which is a constituent material of the heater 151 and the insulating member 158 from reacting with hydrogen and suffering wear and damage.

Also, since the wear and damage of the heater 151 and the insulating member 158 are avoided, even in the case of successive coating processes of the fuel particles, the temperature distribution in the reactor does not vary and is stabilized and hence it is possible to stabilize the quality of the coating layers which play a very important role in the function of confining the fissionable materials in fuel for HTGRs.

As stated above, even when hydrogen contained in the coating material mixed gas as the fluidizing gas leaks out from the gap between the gas inlet nozzle 153 and the reaction vessel 155 during the SiC layer is formed, the hydrogen containing gas is evacuated outside the housing 159 with the suction pump 15A and hence it is possible to prevent graphite which is a constituent material of the heater 151 and the insulating member 158 from reacting with hydrogen and suffering wear and damage.

Further, since the wear and damage of the heater 151 and the insulating member 158 are avoided, even in the case of successive coating processes of the fuel particles, the temperature distribution in the reactor does not vary and is stabilized and hence it is possible to stabilize the quality of the coating layers which play a very important role in the function of confining the fissionable materials in fuel for HTGRs.

(H) Temperature Adjustment of Evaporation Tank:

(Stabilization of SiC coating gas supply)

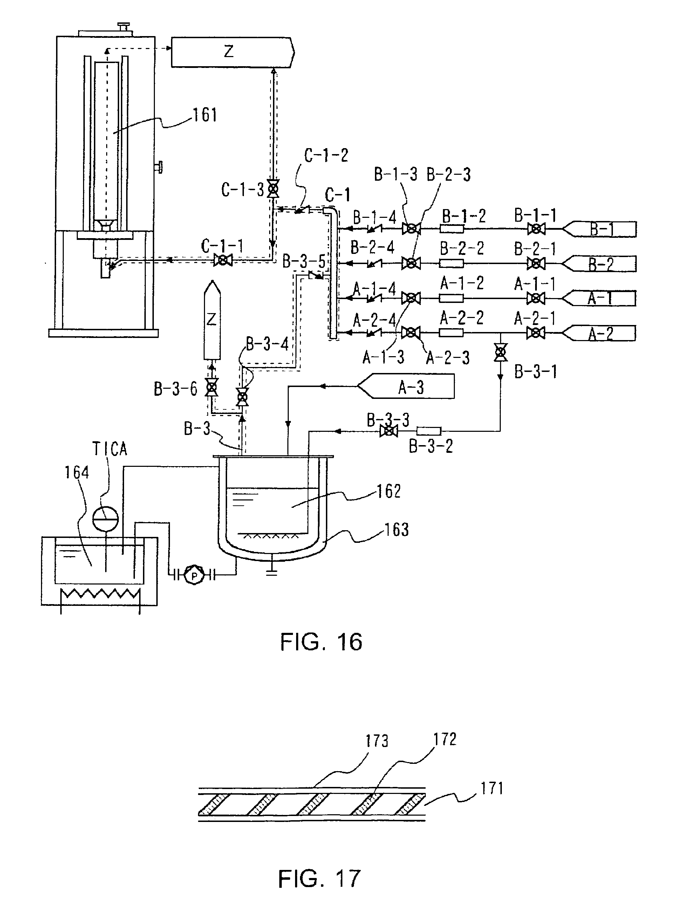

For a fluid ized-bed reaction vessel equipped with a gas inlet nozzle of a type as shown in any one of Figs. 1 to 4, a preferable embodiment of a gas feed system including means for adjusting temperature of an evaporation tank will now be described in detail. Fig. 16 shows a schematic diagram of an gas feed system of a fluidized-bed reaction apparatus for manufacturing coated fuel particles for HTGRs according to one embodiment of the present invention. As shown in Fig. 16, the gas feed system is adapted to independently control the feed amount of each of coating gases B-1 to B-3 and fluidizing gases A-1 to A-2 to be supplied into the fluidized-bed reaction vessel 161 with shut-off valves and flow regulators respectively in the similar way as that of the aforementioned conventional gas feed system. In each of the processes for forming the first, second, and fourth coating layers, a coating material mixed gas obtained by mixing either one or both of coating gases B-1 and B-2 with a fluidizing gas A-1 is used. These coating gases and fluidizing gases are contained in their respective bottles. On the other hand, in the process for forming the third coating layer or SiC layer, a coating material mixed gas obtained by mixing a coating gas B-3 generated from an evaporation tank 162 with a fluidizing gas A-2 contained in a bottle is used as a carrier gas.

Any coating material mixed gases are collected into a collecting pipe C-1 and then supplied into the reaction vessel 161 through a vessel line pipe including an intervening shut-off valve C-1-1. To both the exit and entrance ports of the collecting pipe C-1, their associated check valves C-1-2, A-1-4, A-2-4, B-1-4, B-2-4 and B-3-5 are connected respectively in consideration of preventing the expansion of an accidental explosion of the inflammable gas from the collecting pipe C-1. The operation procedures for the forming processes of the first to fourth coating layers are conducted, for example, according to the following steps.

That is, when the first coating layer is formed, firstly the fluidizing gas A-1 is supplied. The shut-off valves A-1-1 and A-1-3 are opened and the flow rate is adjusted with the flow regulator A-1-2. Successively, the coating gas B-1 is supplied. The shut-off valves B-1-1 and B-1-3 are opened and the flow rate is adjusted with the flow regulator B-1-2.

When the second (or fourth) coating layer is formed, firstly the fluidizing gas A-1 is supplied. The shut-off valves A-1-1 and A-1-3 are opened and the flow rate is adjusted with the flow regulator A-1-2. Successively, the coating gas B-1 (or B-2) is supplied. The shut-off valves B-1-1 and B-1-3 (or B-2-1 and B-2-3) are opened and the flow rate is adjusted with the flow regulator B-1-2 (or B-2-2).

When the third coating layer or an SiC layer is formed, firstly the fluidizing gas A-2 is supplied as a carrier gas. The shut-off valves A-2-1 and A-2-3 are opened and the flow rate is adjusted with the flow regulator A-2-2. Successively, the coating gas B-3 is supplied. The shut-off valves B-3-1, B-3-3 and B-3-4 are opened and flow rate is adjusted with the flow regulator B-3-2.

As shown in Fig. 16, two feed pipes for supplying the fluidizing gases A-1 and A-2 and three feed pipes for supplying the coating gases B-1, B-2 and B-3 are connected to the collecting pipe C-1. All those gases are to be sent into the reaction vessel 161 via the collecting pipe C-1. The inner diameter of the collecting pipe C-1 is not less than twice as large as those of the other feed pipes. Further, the feed pipes are communicated into the collecting pipe C-1 so that each of the coating gases B-1, B-2 and B-3 may be mixed into the primary flow of the associated one of the fluidizing gases A-1 and A-2 and thus uniformly mixed gas is sent to the reaction vessel, for the purpose of supplying the coating material mixed gas homogeneously.

The evaporation tank 162 contains liquid phase methyltrichlorosilane and is equipped with an outer jacket 163 and a temperature regulator 164 for thermostatically control the temperature of the heating fluid circulating in the jacket 163. The temperature regulator 164 is adapted to thermostatically control the temperature of the liquid methyltrichlorosilane in the evaporation tank 162 with a temperature detecting means (not shown) mounted in the evaporation tank 162 so that the temperature of the liquid methyltrichlorosilane in the tank 162 is thermostatically controlled at a predetermined value within the range of 20 °C to 50 °C with an accuracy of plus/minus 1 °C.

Fig. 17 schematically shows a configuration of pipes constituting a gas feed line ranging from the evaporation tank 162 to the interior of the reaction vessel 161. As shown in Fig. 17, the peripheral surface of a pipe 171 constituting respective pipes of the gas feed line ranging from the evaporation tank 162 to the interior of the fluidized-bed reaction vessel 161, which pipes are shown by the parallel doted lines in the figure, is spirally wrapped with a ribbon heater 172 and the outer most surface thereof is sheathed with a lagging 173. The ribbon heater 172 is adapted to maintain the temperature of the pipe surface within a range from about 40 °C to 60 °C with a temperature controller not shown. Consequently, it is possible to prevent an evaporated methyltrichlorosilane gas generated in the tank 162 from being cooled and condensed while the evaporated gas flows in the pipe 171.

Besides that, the exit line from the evaporation tank 162 is also connected to a waste gas exhaust line for purging a remaining gas in the exit line and the tank to a waste gas treatment equipment Z with a cleaning/purge gas A-3 supplied from its bottle through the evaporation tank as occasion demands. Therefore, it is possible to prevent an evaporated gas generated in the tank 162, which may still remain in the exit line and the tank even after the SiC layer is formed, from remaining and being condensed in the exit line pipes. If the evaporated methyltrichlorosilane gas is once condensed in the pipes, the concentration of the evaporated methyltrichlorosilane gas passing through the pipes becomes unstable and as a result the quality (the thickness and the density of the SiC layer and the damage ratio thereof) of thus formed coated fuel particles is adversely affected.

In addition to the above-mentioned waste gas exhaust line for the exit line of the evaporation tank, the gas feed system further comprises a cleaning gas line which is connected to the exit line of the collecting pipe C-1 and leads to a waste gas treatment equipment Z through a shut-off valve C-1-3 so that a remaining coating material mixed gas in the evaporation tank 162 and the line pipes ranging from the exit port of the tank to the vessel line pipe can be purged to the waste gas treatment equipment Z with a cleaning/purge gas A-3 supplied from its bottle through the evaporation tank as occasion demands. Preferably, Ar gas or N2 gas may be used as the cleaning/purge gas A-3.

An experimental example of the successive coating processes will now be explained hereunder. In this case, a gas feed as shown in Fig. 16 was installed in a fluidized-bed reaction apparatus according to the present invention. An argon gas and a hydrogen gas were used as the fluidizing gases A-1 and A-2 respectively and an acetylene gas and a propylene gas were used as the coating gases B-1 and B-2 respectively. As the B-3 gas, a mixed gas obtained by introducing hydrogen gas A-2 into the evaporation tank 162 containing a liquid methyltrichlorosilane therein was used. A thermostatic temperature regulator 164 of an oil circulation type was mounted on the evaporation tank 162 and the temperature of the interior of the tank jacket 163 was thermostatically controlled to a predetermined temperature of 30 °C with the accuracy of plus/minus 1 °C.

All pipes installed in the entire length of the gas feed line, through which the evaporated methyltrichlorosilane gas flows, was made of a heating pipe 171 which is equipped with a spirally wrapped ribbon heater 172 and a lagging sheath 173 as shown in Fig, 17, and the pipes were controlled so that the surface temperature of the entire pipe length might not be lower than 40 °C.

The cleaning gas line leading to the waste gas treatment equipment Z for purging a remaining coating material mixed gas was connected to the vessel line pipe at a position in the vicinity of the exit port of the collecting pipe C-1. On completion of the coating process for the third coating layer or SiC layer, the remaining gas containing methyltrichlorosilane within the line pipes and the tank was forcibly purged with a cleaning gas A-2 and removed into the waste gas treatment equipment.

Using the apparatus of the above configuration, uranium dioxide fuel kernels 0.6 mm in average diameter of a batch amount of about 3.8 kg were charged into the reaction vessel (about 200 mm in inner diameter) through a charging hole at the top of the vessel while an Ar fluidizing gas flow of 150L/min was introduced into the vessel. The charging hole was tightly closed, and then a first coating layer or a low-density carbon layer (0.06 mm in average thickness with an accuracy of plus/minus 0.01 mm and 1.1 g/cm$^3$ in average density) was formed at about 1,400 °C, while an acetylene ($C_2H_2$) gas flow was introduced into the vessel from the gas feed system. Successively, a second coating layer or high-density pyrolytic carbon (0.03 mm in average thickness with an accuracy of plus/minus 0.002 mm and 1.85 g/cm$^3$ in average density) was formed at about 1,450 °C, while a propylene ($C_3H_6$) gas flow was introduced into the vessel from the gas feed system. Thereafter, the shut-off valves and flow regulators in the gas feed system were changed in their respective operational condition so that an $H_2$ carrier gas flow of 7 L/min was introduced into the evaporation tank in which a liquid phase methyltrichlorosilane was maintained at 30 °C, and thus evaporated methyltrichlorosilane emission from the tank was mixed with an $H_2$ fluidizing gas flow of 380 L/mm in the collecting pipe and fed through the gas feed line kept at a predetermined pipe surface temperature (not lower than 40 °C) to the reaction vessel as an SiC coating material mixed gas. With this mixed gas supplied, a third coating layer or an SiC layer (0.03 mm in average thickness with an accuracy of plus/minus 0.002 mm and 1.85 g/cm$^3$ in average density) was formed in the vessel with the SiC coating material mixed gas flow at about 1,600°C.

After the third coating layer was formed, the methyltrichlorosilane which remained in the line pipes was removed by opening the shut-off valves in the waste gas cleaning line and the waste gas exhaust line for about five minutes. Then finally, the fuel kernels were coated with a fourth coating layer of high-density pyrolytic carbon (0.04 mm in average thickness with an accuracy of plus/minus 0.004 mm and 1.85 g/m$^3$ in average density) at about 1,450 °C with an argon fluidizing gas flow of 170 L/min and a propylene ($C_3H_6$) coating gas of 30 L/min, and thus the resultant average diameter of thus obtained coated fuel particles was 0.92 mm.

Thus obtained coated fuel particles were cooled to about 100 °C, thereafter the flow rate of the argon fluidizing gas was reduced to 80 L/min, and the coated fuel particles were collected in a discharge container. Thus collected coated fuel particles were free from defects and damages of the coating layers, and the densities and the thicknesses of the coating layers as well as the damage ratio of the SiC layer were all satisfactory (the SiC layer damage ratio was $1.4 \times 10^{-4}$ or less).

As stated above, the fluidized-bed reaction apparatus according to the present embodiment comprises a gas feed system including a thermostatically controlled evaporation tank for generating a methyltrichlorosilane evaporated gas and therefore, the following advantage may be realized. That is, in the case of the forming process of an SiC coating layer, an $H_2$ fluidizing gas mixed with a coating gas ($H_2$ carrier gas and methyltrichlorosilane evaporated gas) is used and possible problems here are that the temperature of a methyltrichlorosilane evaporated gas generated in the evaporation tank may be decreased due to the contact with the $H_2$ fluidizing gas as well as the contact with the feed line pipes, the methyltrichlorosilane evaporated gas is liquefied locally in the pipes when the low temperature condition is lasted, and resultantly the thickness and the density of the SiC layer and the like of the final product may be affected. To cope with the problems in the present embodiment, a temperature regulator of an oil circulation type is mounted on the evaporation tank and the temperature of the methyltrichlorosilane can be thermostatically controlled at a predetermined temperature, for example, in the range of 20 °C to 50 °C with an accuracy of plus/minus 1 °C. Consequently, the amount of evaporation of methyltrichlorosilane can be stably maintained at a target value.

Further, the surface temperature of the line pipes ranging from the exit port of the evaporation tank to the inlet port of the fluidized-bed reaction vessel is controlled with a ribbon heater or the like so that the surface temperature of the entire pipe length is kept at 40 °C or higher and the methyltrichlorosilane is prevented from condensation. Also, the gas feed system comprises a cleaning gas line and a waste gas exhaust line which are connected to the exit line of the collecting pipe and the exit line of the evaporation tank respectively so that a remaining gas in the evaporation tank and the line pipes can be purged to a waste gas treatment equipment Z with a cleaning/purge gas supplied through the evaporation tank as occasion demands after completion of the coating process for the third coating layer or SiC layer.

(I) Piping of Methyltrichlorosilane Feed Line:

(Stabilization of SiC coating gas supply)

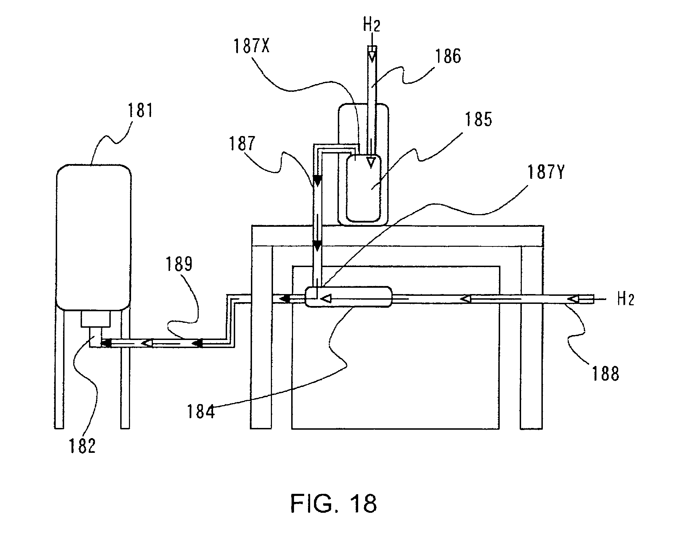

For a fluidized-bed reaction apparatus according to the present invention, a preferable example of a gas feed system for supplying methyltrichlorosilane in gas phase as an SiC coating material mixed gas for forming a silicon carbide layer as the aforementioned third coating layer will now be described in detail. Fig. 18 shows a schematic configuration of a gas feed line for supplying an evaporated methyltrichlorosilane from an evaporation tank to the fluidized-bed reaction vessel through a vessel line pipe during the aforementioned forming process of the SiC coating layer. In the figure, line pipes for supplying the other coating material mixed gases than the SiC coating material mixed gas are omitted.

The apparatus comprises a fluidized-bed reactor 181 for manufacturing coated fuel particles for HTGRs. The reactor has a double wall structure including an airtight cylindrical housing and a graphite-made reaction vessel functioning as a fluidized bed coaxially disposed in the housing. Within the housing, the outer periphery of the reactor vessel is surrounded by an cylindrical heater made of graphite, and the outer periphery of the heater is further surrounded by a cylindrical insulating member made of graphite, so that the inner chamber of the reaction vessel is heated to a high temperature required for the thermal decomposition a coating material mixed gas and the coating reaction with surfaces of fuel kernels charged in the reaction vessel. The reactor further comprises a gas inlet pipe 182 communicating into the inner chamber of the reaction vessel so that the coating material mixed gas is supplied from the gas feed system into the reaction vessel through the gas inlet pipe.

The gas feed system comprises a vessel line pipe, the exit end of which is connected to the gas inlet pipe 182 of the reactor. The gas feed system further comprises a collecting pipe 184, the exit end of which is connected to the inlet end of the vessel line pipe 189. A plurality of gas feed line pipes each extending from their respective gas supply sources for forming the respective coating layers are connected to the collecting pipe 184 so that each of the coating material mixed gasses is fed through the collecting pipe 184 and the vessel line pipe 189 into the gas inlet pipe 182 of the reactor 181. One of the gas feed line pipes is shown in the figure with a reference numeral 188 which introduce a high flow rate hydrogen gas as a fluidizing gas into the collecting pipe 184.

Consequently, the coating material mixed gas introduced from the vessel line pipe 189 through the gas inlet pipe 182 is continuously supplied into the inner chamber of the reaction vessel with a sufficient fluidizing gas flow, and thereby blows up and fluidizes fuel kernels which are charged into the reaction vessel. The fuel kernels are reacted with the coating material mixed gas in the fluidized state, the coating material molecules of the gas is thermally decomposed by heat and evenly deposit on the surfaces of the fuel kernels to form a coating layer. Then the resultant waste gas is discharged from an exhaust port formed at the top of the reactor.

The present example relates to an apparatus for manufacturing coated fuel particles each having a fourfold layer which is composed of a low-density carbon layer as the first coating layer formed by thermal decomposition using acetylene, two high-density pyrolytic carbon layers as the second and fourth coating layers each formed by thermal decomposition using propylene and an SiC layer as the third coating layer formed by thermal decomposition using methyltrichlorosilane ($CH_3SiCl_3$) containing gas. In this case, whereas the acetylene and the propylene are supplied from their respective bottles as they are in the states of gases, the methyltrichlorosilane, which is the coating material of the third coating layer and normally in the liquid phase, is supplied in the form of a mixed gas generated through the bubbling of the liquid methyltrichlorosilane in an evaporation tank 185 with hydrogen gas supplied from a carrier gas pipe 186.

In the present example, a gas outlet 187X of a methyltrichlorosilane feed pipe 187, through which the mixed gas containing the evaporated methyltrichlorosilane is supplied from the evaporation tank 185 to the collecting pipe 184, is located at a position above the gas inlet pipe 182 and the evaporation tank 185 is located at a position immediately above the collecting pipe 184 in such a manner that the methyltrichlorosilane feed pipe 187 vertically extends to a confluent portion 187Y with the collecting pipe 184 which is the exit port communicating with the vessel line pipe 189. Further, the collecting pipe 184 is also located at a position above the gas inlet pipe 182 and the reaction vessel pipe 189 is placed only downward in the direction from the collecting pipe 184 toward the gas inlet pipe 182.

According to such arrangement of the gas feed line in the gas feed system as described above, the methyltrichlorosilane containing gas flows substantially vertically downward toward the collecting pipe 184 in the methyltrichlorosilane feed pipe 187 where accumulation of methyltrichlorosilane has heretofore been likely to occur, hence the methyltrichlorosilane which has a larger specific gravity than hydrogen gas as the carrier gas and tends to settle by the gravity is very smoothly fed to the vessel line pipe 189 with the flow of not defying the gravity, and resultantly the supply of the methyltrichlorosilane as the coating material mixed gas to the reaction vessel is much stabilized.

Further, the vessel line pipe 189 ranging from the collecting pipe 184 to the gas inlet pipe 182 is also arranged only downward, the flow of the methyltrichlorosilane in the vessel line pipe 189 is also smoothed with very scarce pressure loss with the help of the flow of the high flow rate hydrogen carrier gas, and the methyltrichlorosilane as the coating material mixed gas is stably supplied from the tank 185 to the reaction vessel in the reactor 181 smoothly over the entire line pipes.

Using the apparatus of the above configuration, several batch amounts of fuel kernels were subjected to reaction for forming coating layers up to the aforementioned third layer which used methyltrichlorosilane as the material of an SiC layer and thereby coated fuel particles each having a threefold coating layer were produced. The average thickness of the third coating layers of the particles corresponding to one hundred particles taken from five batches of the production processes was measured. As a result, very uniform SiC coating layers generally ranging from 30.6 to 30.8 micrometers were formed.

(J) Manufacturing Conditions of Coated Fuel Particles:

Among the manufacturing processes of about two tons-U coated fuel particles of the primary loading fuel and the first replacing fuel which were to be loaded in the High Temperature engineering Test Reactor (HTTR) of the Japan Atomic Energy Research Institute, the processes for successively coating uranium dioxide fuel kernels with the low-density carbon layer as the first layer, the high-density pyrolytic carbon layer as the second layer, the SiC layer as the third layer, and the high-density pyrolytic carbon layer as the fourth layer were carried out. In the event of deciding the coating conditions, the rate of temperature rise, the coating temperature, the coating gas flow rate, the fluidizing gas flow rate, and the coating speed were optimized.

(1) With regard to the coating conditions of the low-density carbon layer as the first layer, the rate of temperature rise in the temperature range from the room temperature to the first layer coating temperature, the coating temperature, the coating gas flow rate, the fluidizing gas flow rate, and the coating speed were variously changed.

When the rate of temperature rise exceeded 25 °C/min in the temperature range from the room temperature to the first layer coating temperature, the fuel kernels having internal defects broke sometimes due to thermal stress and hence the rate of temperature rise had to be 25 °C/min or lower. Further, when the coating temperature was lower than 1,300 °C, the thermal decomposition reaction of acetylene did not advance, the decomposition was insufficient, and a sound low-density carbon layer could not be formed. On the other hand, when the coating temperature exceeded 1,500 °C, the reaction with $UO_2$ in the fuel kernels occurred and UCO was formed.

When the coating gas (acetylene) flow rate was less than 60 L/min, the coating speed could not be increased to 10 micrometer/min or higher even when the coating temperature was 1,500 °C. On the other hand, when the coating gas flow rate exceeded 220 L/min, the fluidization of the particles was violent and the breakage of the coating layer occurred even when the fluidizing gas (argon) flow rate was lowered to the minimum value of 90 L/min.

When the fluidizing gas (argon) flow rate was less than 90 L/min, the fluidization of the particles was insufficient and a uniform coating layer could not be formed. On the other hand, when the fluidizing gas flow rate exceeded 250 L/min, the fluidization of the particles was violent and the breakage of the coating layer occurred even when the coating gas (acetylene) flow rate was lowered to the minimum value of 60 L/min.

When the coating speed was lower than 10 micrometer/min, the coating layer having fewer pores was formed and the primary function of the coating layer as the buffer to absorb the gas accumulation of gaseous FP generated through nuclear fission reaction and the swelling of the particles was insufficient. The density of the coating layer tended to lower when the coating speed increased but the upper limit thereof was not observed.

(2) With regard to the coating conditions of the high-density pyrolytic carbon layer as the second layer, the rate of temperature rise in the temperature range from the first layer coating temperature to the second layer coating temperature, the coating temperature, the coating gas flow rate, the fluidizing gas flow rate, and the coating speed were variously changed.

When the rate of temperature rise exceeded 25 °C/min in the temperature range from the first layer coating temperature to the second layer coating temperature, the fuel kernels having internal defects broke sometimes due to thermal stress and hence the rate of temperature rise had to be 25 °C/min or lower. Further, when the coating temperature was lower than 1,350 °C, the thermal decomposition reaction of propylene did not advance, the decomposition was insufficient, and a sound high-density carbon layer could not be formed. On the other hand, when the coating temperature exceeded 1,480 °C, the coating speed was hardly controlled and a coating layer having a uniform thickness and a uniform structure was not obtained.

When the coating gas (propylene) flow rate was less than 30 L/min, the value of the expression "Flow rate of the coating gas/(Flow rate of the coating gas + Flow rate of the fluidizing gas)" decreased. That is, the concentration of the coating gas decreased and the density of the coating layer undesirably lowered. On the other hand, when the coating gas flow rate exceeded 190 L/min, the fluidization of the particles was violent and the breakage of the coating layer occurred even when the fluidizing gas (argon) flow rate was lowered to the minimum value of 140 L/min.

When the fluidizing gas (argon) flow rate was less than 140 L/min, the fluidization of the particles was insufficient and a uniform coating layer could not be formed. On the other hand, when the fluidizing gas flow rate exceeded 190 L/min, the fluidization of the particles was violent and the breakage of the coating layer occurred even when the coating gas (propylene) flow rate was lowered to the minimum value of 30 L/min. Further, when the coating speed exceeded 4 micrometer/min, a coating layer having a uniform thickness and a uniform structure was not obtained.

(3) With regard to the coating conditions of the SiC layer as the third layer, the rate of temperature rise in the temperature range from the second layer coating temperature to the third layer coating temperature, the coating temperature, the coating gas flow rate, the fluidizing gas flow rate, and the coating speed were variously changed.

When the rate of temperature rise exceeded 25 °C/min in the temperature range from the second layer coating temperature to the third layer coating temperature, the fuel kernels having internal defects broke sometimes due to thermal stress and hence the rate of temperature rise had to be 25 °C/min or lower.

When the coating temperature was lower than 1,500 °C, free Si, which did not take the form of SiC, was generated and hence the ratio Si/C was larger than one. When the ratio Si/C was not equal to one, the properties of SiC deteriorated. Further, sediments comprising SiC were formed at the coating gas ejection port of the coating apparatus, thus the fluidizing state was adversely affected, and hence a uniform coating was not obtained. On the other hand, when the coating temperature exceeded 1,650 °C, the lamination defects occurred in the coating layer, particles stuck to the coating gas ejection port of the coating apparatus and formed sediments, thus the fluidizing state was adversely affected, and hence a uniform coating was not obtained.

When the flow rate of hydrogen gas for transporting methyltrichlorosilane as the coating gas was less than 5 L/min, the concentration of the coating gas decreased and the density of the coating layer undesirably lowered. On the other hand, when the flow rate of hydrogen gas exceeded 9 L/min, excessive methyltrichlorosilane formed sediments at the coating gas ejection port of the coating apparatus, thus the fluidizing state was adversely affected, and hence a uniform coating was not obtained.

When the fluidizing gas (hydrogen) flow rate was less than 350 L/min, the fluidization of the particles was insufficient and a uniform coating layer could not be formed. On the other hand, when the fluidizing gas flow rate exceeded 450 L/min, the fluidization of the particles was violent and the breakage of the coating layer occurred. Further, when the coating speed exceeded 0.3 micrometer/min, lamination defects occurred.

(4) With regard to the coating conditions of the high-density pyrolytic carbon layer as the fourth layer, the rate of temperature drop in the temperature range from the third layer coating temperature to the fourth layer coating temperature was set at 20 °C/min or lower, the coating temperature was set at 1,350 °C to 1,520 °C, the coating gas (propylene) flow rate was set at 35 to 110 L/min, the fluidizing gas (argon) flow rate was set at 65 to 240 L/min, and the coating speed was set at 1.7 to 3.4 micrometer/min.

When the rate of temperature drop exceeded 20 °C/min in the temperature range from the third layer coating temperature to the fourth layer coating temperature, the exfoliation and the breakage of the coating layer sometimes occurred and hence the rate of temperature drop had to be 20 °C/min or lower. Further, when the coating temperature was lower than 1,350 °C, the thermal decomposition reaction of propylene did not advance, the decomposition was insufficient, and a sound high-density carbon layer could not be formed. On the other hand, when the coating temperature exceeded 1,520 °C, the coating speed was hardly controlled and a coating layer having a uniform thickness and a uniform structure was not obtained.

When the coating gas (propylene) flow rate was less than 30 L/min, the concentration of the coating gas decreased and the density of the coating layer undesirably lowered. On the other hand, when the coating gas flow rate exceeded 110 L/min, the fluidization of the particles was violent and the breakage of the coating layer occurred even when the fluidizing gas (argon) flow rate was lowered to the minimum value of 35 L/min. Further, when the coating speed exceeded 3.4 micrometer/min, a coating layer having a uniform thickness and a uniform structure was not obtained.

(5) The rate of temperature drop after the end of the forming of the high-density carbon layer as the fourth layer was set at 20 °C/min or lower. The reason was that, when the rate of temperature drop after the end of the forming of the fourth layer exceeded 20 °C/min, the exfoliation and the breakage of the coating layer sometimes occurred due to the difference in thermal contraction coefficient between the SiC layer and the high-density carbon layer.

About 600 batches of coated fuel particles were manufactured through the processes of successively coating uranium dioxide fuel kernels with the low-density carbon layer as the first layer, the high-density pyrolytic carbon layer as the second layer, the SiC layer as the third layer, and the high-density pyrolytic carbon layer as the fourth layer. The obtained coated fuel particles had the coating layers of the following thicknesses and densities respectively in a stable manner. The average thickness and the average density of each coating layer are shown in the following Table 1.

Table 1

| | Thickness (mm) | Density (g/cm$^3$) |
|---|---|---|
| First layer | 60 | 1.1 |
| Second layer | 30 | 1.85 |
| Third layer | 30 | 3.2 |
| Fourth layer | 45 | 1.85 |

Further, with regard to the function of confining the fission products generated by nuclear fission reaction when coated fuel particles were used in a nuclear reactor too, as a result of high-temperature running tests of the primary loading fuel which was currently under combustion at a temperature of 950 °C, the ratio of the emitted amount of the fission products to the produced amount of the fission products was the order of $10^{-8}$ and it was verified that the coated fuel particles having the coating layers of very high quality could be manufactured stably on an industrial scale.

**Claims**

1.  An apparatus for manufacturing coated fuel particles for a high temperature gas-cooled reactor, the apparatus being equipped with a fluidized-bed reaction vessel having a gas inlet nozzle (1, 31, 41) at the bottom of the vessel for forming a multilayered coating on each of the surfaces of a batch amount of fuel kernels formed with a sintered uranium dioxide by introducing a coating material mixed gas which contains a coating gas and/or a fluidizing gas from said gas inlet nozzle (1, 31, 41) into the interior thereof under a heated environment while the fuel kernels are fluidized, a heater (54) disposed around the fluidized-bed reaction vessel to heat the same, an insulating member (56) surrounding the outer periphery of the heater (54) and accommodates the fluidized-bed reaction vessel therein, and a cylindrical housing (119) for accommodating the fluidized-bed reaction vessel, the heater (54) and the insulating member (56) therein,
    wherein said gas inlet nozzle (1, 31, 41) comprises:

    a dish-shaped nozzle body (2, 32, 42) fitted into the bottom of the reaction vessel to constitute at least a part of the bottom centre part of the vessel;
    a plurality of nozzle openings (5a, 5b, 5c; 35a, 35b, 35c; 45a, 45b, 45c) disposed on the nozzle body at positions allocated along a plurality of circular zones (C) which arc concentric with each other around the centre axis (A) of said bottom of the reaction vessel;
    one or more gas inlet channels (4a, 4b, 4c; 34a, 34b, 34c; 44a, 44b, 44c) passing through the nozzle body and communicating with the nozzle openings (5a, 5b, 5c) from the bottom surface side of the vessel; and
    one or more gas inlet pipes (15, 25) communicating with the one or more gas inlet channels (4a, 4h, 4c; 34a, 34b, 34e; 44a, 44b, 44c) and supplying the coating material mixed gas to the channels from a gas feed system disposed on the outside of the reaction vessel,

    and wherein the apparatus further comprises:

    a sweep gas feed pipe (74) for supplying a sweep gas into a space outside the fluidized-bed reaction vessel within the cylindrical housing (119) in order to purge a coating material mixed gas leaked out from the reaction vessel to the exterior of the cylindrical housing (119); and
    a circumferential inner flow channel (14B) disposed between the fluidized-bed reaction vessel and the insulating member (56) with a clearance of a uniform width all around the circumference thereof so as to stream the sweep gas without stagnation,

    the apparatus being **characterized in that** it further comprises an outer flow channel disposed between the insulating member and the cylindrical housing (119) with a clearance of a uniform width all around the circumference thereof so as to stream the sweep gas without stagnation.

2.  An apparatus for manufacturing coated fuel particles for a high temperature gas-cooled reactor, the apparatus being equipped with a fluidized-bed reaction vessel having a gas inlet nozzle (1, 31, 41) at the bottom of the vessel for forming a multilayered coating on each of the surfaces of a batch amount of fuel kernels formed with a sintered uranium dioxide by introducing a coating material mixed gas which contains a coating gas and/or a fluidizing gas from said gas inlet nozzle (1, 31, 41) into the interior thereof under a heated environment while the fuel kernels are fluidized, a heater (54) disposed around the fluidized-bed reaction vessel to heat the same, an insulating member (56) surrounding the outer periphery the fluidized-bed reaction vessel therein, and a cylindrical housing (119) for accommodating the fluidized-bed reaction vessel, the heater (54) and the insulating member (56) therein,
wherein said gas inlet nozzle (1, 31, 41) comprises:

a dish-shaped nozzle body (2, 32, 42) fitted into the bottom of the reaction vessel to constitute at least a part of the bottom centre part of the vessel;
a plurality of nozzle openings (5a, 5b, 5c; 35a, 35b, 35c; 45a, 45b, 45c) disposed on the nozzle body (2, 32, 42) at positions allocated along a plurality of circular zones (C) which arc concentric with each other around the centre axis of said bottom of the reaction vessel;
one or more gas inlet channels (4a, 4b, 4c; 34a, 34b, 34c; 44a, 44b, 44c) passing through the nozzle body (2, 32, 42) and communicating with the nozzle openings (5a, 5b, 5e; 35a, 35b, 35c; 45a, 45b, 45c) from the bottom surface side of the vessel; and
one or more gas inlet pipes (15, 25) communicating with the one or more gas inlet channels (5a, 5b, 5e; 35a, 35b, 35c; 45a, 45b, 45c) and supplying the coating material mixed gas to the channels from a gas feed system disposed on the outside of the reaction vessel,
the apparatus being **characterized in that**
it further comprises a suction pump (15A) for discharging a coating material mixed gas leaked out from the fluidized-bed reaction vessel to the exterior of the housing.

**3.** The apparatus according to claim 2, wherein said gas feed system comprises an evaporation tank (162) for generating a coating gas to be supplied into the reaction vessel in order to form a silicon carbide coating layer on each of the surfaces of the fuel kernels in the reaction vessel, and temperature regulating means (164) for thermostatically control the operational temperature of the evaporation tank (162).

**4.** The apparatus according to claim 2, wherein said gas feed system comprises an evaporation tank (162) for generating a coating material mixed gas to he supplied into the reaction vessel, a line pipe constituting a gas feed line for feeding said coating material mixed gas from the evaporation tank (162) to the fluidized-bed reaction vessel, and temperature retaining means for retaining the temperature of the line pipe over a predetermined temperature when a silicon carbide coating layer is formed on each of the surfaces of the fuel kernels.

**Patentansprüche**

**1.** Vorrichtung zur Herstellung beschichteter Brennstoffpartikel für einen gasgekühlten Hochtemperaturreaktor, wobei die Vorrichtung ausgestattet ist mit einem Wirbelschichtreaktionsbehälter, der eine Gaseinlassdüse (1, 31, 41) am Boden des Behälters aufweist, zum Bilden einer mehrschichtigen Beschichtung auf jeder der Oberflächen einer Bündelmenge eines Brennstoffkems, der mit einem gesinterten Urandioxid gebildet ist, durch das Einführen eines Beschichtungsmaterialmischgases, das ein Beschichtungsgas und/oder ein Wirbelgas enthält, von der Gaseinlassdüse (1, 31, 41) aus in dessen Innenraum in einer erhitzten Umgebung, während die Brennstoffkerne verwirbelt werden, einem Heizer (54), der um den Wirbelschichtreaktionsbehälter herum angeordnet ist, um selbigen zu heizen, einem isolierenden Element (56), das die äußere Begrenzungsfläche des Heizers (54) ummantelt und den Wirbelschichtreaktionsbehälter aufnimmt, und einem zylindrischen Gehäuse (119) zum Aufnehmen des Wirbelschichtreaktionsbehälters, des Heizers (54) und des isolierenden Elementes (56),
wobei die Gaseinlassdüse (1, 31, 51) umfasst:

einen tellerförmigen Düsenkörper (2, 32, 42), der in den Boden des Reaktionsbehälters eingepasst ist, um wenigstens einen Teil des Mittelteils des Bodens des Behälters zu bilden;
eine Mehrzahl von Düsenöffnungen (5a, 5b, 5c, 35a, 35b, 35c, 45a, 45b, 45c), die auf dem Düsenkörper an Stellen verteilt entlang einer Vielzahl von kreisförmigen Gebieten (C) angeordnet sind, welche um die Mittelachse (A) des Bodens des Reaktionsbehälters konzentrisch zueinander angeordnet sind;
einen oder mehrere Gaseinlasskanäle (4a, 4b, 4c, 34a, 34b, 34c, 44a, 44b, 44c), die durch den Düsenkörper hindurchlaufen und mit den Düsenöffnungen (5a, 5b, 5c) von der Bodenoberflächenseite des Behälters aus in Verbindung stehen; und
eine oder mehrere Gaseinlassleitungen (15, 25), die mit einem oder mehreren Gaseinlasskanälen (4a, 4b, 4c, 34a, 34b, 34c, 44a, 44b, 44c) in Verbindung stehen und die den Kanälen das Beschichtungsmaterialmischgas von einem Gaszuführsystem, das außerhalb des Reaktionsbehälters angeordnet ist, bereitstellen;

und wobei die Vorrichtung weiterhin umfasst:

eine Durchlaufgaszuführleitung (74) zur Bereitstellung eines Durchlaufgases in einen Bereich außerhalb des Wirbelschichtreaktionsbehälters innerhalb des zylindrischen Gehäuses (119), um Beschichtungsmaterialmischgas, das aus dem Reaktionsbehälter zur Außenseite des zylindrischen Gehäuses (119) hin entwichen ist, zu beseitigen; und
einen umlaufenden inneren Fließkanal (14B), der zwischen dem Wirbelschichtreaktionsbehälter und dem isolierenden Element (56) mit einem Freiraum gleichbleibender Breite ringsum dessen Umfangs angeordnet ist, um das Durchlaufgas ohne Stagnation zu verströmen,

**dadurch gekennzeichnet, dass** die Vorrichtung des Weiteren einen äußeren Fließkanal umfasst, der zwischen dem isolierenden Element und dem zylindrischen Gehäuse (119) mit einem Freiraum gleichbleibender Breite ringsum dessen Umfanges angeordnet ist, um das Durchlaufgas ohne Stagnation zu verströmen.

2. Vorrichtung zur Herstellung beschichteter Brennstoffpartikel für einen gasgekühlten Hochtemperaturreaktor, wobei die Vorrichtung ausgestattet ist mit einem Wirbelschichtreaktionsbehälter, der eine Gaseinlassdüse (1, 31, 41) am Boden des Behälters aufweist, zum Bilden einer mehrschichtigen Beschichtung auf jeder der Oberflächen einer Bündelmenge eines Brennstoffkerns, der mit einem gesinterten Urandioxid gebildet ist, durch das Einführen eines Beschichtungsmaterialmischgases, das ein Beschichtungsgas und/oder ein Wirbelgas enthält, von der Gaseinlassdüse (1, 31, 41) aus in dessen Innenraum in einer erhitzten Umgebung, während die Brennstoffkerne verwirbelt werden, einem Heizer (54), der um den Wirbelschichtreaktionsbehälter herum angeordnet ist, um selbigen zu heizen, einem isolierenden Element (56), das die äußere Begrenzungsfläche des Wirbelschichtreaktionsbehälter ummantelt, und einem zylindrischen Gehäuse (119) zum Aufnehmen des Wirbelschichtreaktionsbehälters, des Heizers (54) und des isolierenden Elementes (56),
wobei die Gaseinlassdüse (1, 31, 51) umfasst:

einen tellerförmigen Düsenkörper (2, 32, 42), der in den Boden des Reaktionsbehälters eingepasst ist, um wenigstens einen Teil des Mittelteils des Bodens des Behälters zu bilden;
eine Mehrzahl von Düsenöffnungen (5a, 5b, 5c, 35a, 35b, 35c, 45a, 45b, 45c), die auf dem Düsenkörper (2, 32, 42) an Stellen verteilt entlang einer Vielzahl von kreisförmigen Gebieten (C) angeordnet sind, welche um die Mittelachse des Bodens des Reaktionsbehälters konzentrisch zueinander angeordnet sind;
einen oder mehrere Gaseinlasskanäle (4a, 4b, 4c, 34a, 34b, 34c, 44a, 44b, 44c), die durch den Düsenkörper (2, 32, 42) hindurchlaufen und mit den Düsenöffnungen (5a, 5b, 5c) von der Bodenoberflächenseite des Behälters aus in Verbindung stehen; und
eine oder mehrere Gaseinlassleitungen (15, 25), die mit einem oder mehreren Gaseinlasskanälen (4a, 4b, 4c, 34a, 34b, 34c, 44a, 44b, 44c) in Verbindung stehen und die den Kanälen das Beschichtungsmaterialmischgas von einem Gaszuführsystem, das außerhalb des Reaktionsbehälters angeordnet ist, bereitstellen,
**dadurch gekennzeichnet, dass** die Vorrichtung des Weiteren eine Absaugpumpe (15A) zum Abführen eines Beschichtungsmaterialmischgas, das aus dem Wirbelschichtreaktionsbehälter zur Außenseite des Gehäuses hin entwichen ist, umfasst.

3. Vorrichtung nach Anspruch 2, wobei das Gaszuführsystem einen Verdampfungsbehälter (162) zur Erzeugung eines Beschichtungsgases, das in die Reaktionskammer bereitgestellt wird, um eine Silikonkarbid-Beschichtungsschicht auf jeder der Oberflächen des Brennstoffkerns in dem Reaktionsbehälter zu bilden, und eine Temperaturregelvorrichtung (164), um die Betriebstemperatur des Verdampfungsbehälters (162) thermostatisch zu kontrollieren, umfasst.

4. Vorrichtung nach Anspruch 2, wobei das Gaszuführsystem einen Verdampfungsbehälter (162) zur Erzeugung eines Beschichtungsmaterialmischgases, das in die Reaktionskammer bereitgestellt wird, ein Leitungsrohr, das eine Gaszuführleitung zum Zuführen von Beschichtungsmaterialmischgas von dem Verdampfungsbehälter (162) in den Wirbelschichtreaktionsbehälter darstellt, und eine Temperaturhaltevorrichtung zum Halten der Temperatur des Leitungsrohres über einer vordefinierten Temperatur, wenn die Silikonkarbid-Beschichtungsschicht auf jeder der Oberflächen des Brennstoffkerns gebildet wird, umfasst.

**Revendications**

1. Appareil pour fabriquer des particules de combustible enrobées pour un réacteur à haute température refroidi au gaz, l'appareil étant équipé avec une cuve de réaction à lit fluidisé ayant une buse d'entrée de gaz (1, 31, 41) au fond de la cuve pour former un enrobage multicouche sur chacune des surfaces d'une quantité de charge de noyaux de combustible formés avec un dioxyde d'uranium fritté en introduisant un gaz mélangé de matériau d'enrobage qui contient un gaz d'enrobage et/ou un gaz de fluidisation à partir de ladite buse d'entrée de gaz (1, 31, 41) dans son intérieur sous un environnement chauffé alors que les noyaux de combustible sont fluidisés, un dispositif de chauffage (54) disposé autour de la cuve de réaction à lit fluidisé pour chauffer cette dernière, un élément isolant (56) entourant la périphérie externe du dispositif de chauffage (54) et loge la cuve de réaction à lit fluidisé à l'intérieur de ce dernier, et un boîtier cylindrique (119) pour loger la cuve de réaction à lit fluidisé, le dispositif de chauffage (54) et l'élément isolant (56) à l'intérieur de ce dernier,
   dans lequel ladite buse d'entrée de gaz (1, 31, 41) comprend :

   un corps de buse en forme de cuvette (2, 32, 42) monté au fond de la cuve de réaction pour constituer au moins une partie de la partie centrale inférieure de la cuve ;
   une pluralité d'ouvertures de buse (5a, 5b, 5c ; 35a, 35b, 35c ; 45a, 45b, 45c) disposées sur le corps de buse dans des positions situées le long d'une pluralité de zones circulaires (C) qui sont concentriques les unes par rapport aux autres autour de l'axe central (A) dudit fond de la cuve de réaction ;
   un ou plusieurs canaux d'entrée de gaz (4a, 4b, 4c ; 34a, 34b, 34c ; 44a, 44b, 44c) passant par le corps de buse et communiquant avec les ouvertures de buse (5a, 5b, 5c) à partir du côté de surface inférieure de la cuve ; et
   un ou plusieurs tuyaux d'entrée de gaz (15, 25) communiquant avec les un ou plusieurs canaux d'entrée de gaz (4a, 4b, 4c ; 34a, 34b, 34c ; 44a, 44b, 44c) et amenant le gaz mélangé de matériau d'enrobage aux canaux à partir d'un système d'alimentation en gaz disposé sur l'extérieur de la cuve de réaction,

   et dans lequel l'appareil comprend en outre :

   un tuyau d'alimentation en gaz de balayage (74) pour amener un gaz de balayage dans un espace à l'extérieur de la cuve de réaction à lit fluidisé à l'intérieur du boîtier cylindrique (119) afin de purger un gaz mélangé de matériau d'enrobage qui fuit de la cuve de réaction vers l'extérieur du boîtier cylindrique (119) ; et
   un canal d'écoulement interne circonférentiel (14B) disposé entre la cuve de réaction à lit fluidisé et l'élément isolant (56) avec un jeu d'une largeur uniforme tout autour de sa circonférence afin de permettre l'écoulement du gaz de balayage sans stagnation,
   l'appareil étant **caractérisé en ce qu'**il comprend en outre un canal d'écoulement externe disposé entre l'élément isolant et le boîtier cylindrique (119) avec un jeu d'une largeur uniforme tout autour de sa circonférence afin de permettre l'écoulement du gaz de balayage sans stagnation.

2. Appareil pour fabriquer des particules de combustible enrobées pour un réacteur à haute température refroidi au gaz, l'appareil étant équipé avec une cuve de réaction à lit fluidisé ayant une buse d'entrée de gaz (1, 31, 41) au fond de la cuve pour former un enrobage multicouche sur chacune des surfaces d'une quantité de charge de noyaux de combustible formés avec un dioxyde d'uranium fritté en introduisant un gaz mélangé de matériau d'enrobage qui contient un gaz d'enrobage et/ou un gaz de fluidisation à partir de ladite buse d'entrée (1, 31, 41) dans son intérieur sous un environnement chauffé alors que les noyaux de combustible sont fluidisés, un dispositif de chauffage (54) disposé autour de la cuve de réaction à lit fluidisé pour chauffer cette dernière, un élément isolant (56) entourant la périphérie externe loge la cuve de réaction à lit fluidisé à l'intérieur de ce dernier, et un boîtier cylindrique (119) pour loger la cuve de réaction à lit fluidisé, le dispositif de chauffage (54) et l'élément isolant (56) à l'intérieur de ce dernier,
   dans lequel ladite buse d'entrée de gaz (1, 31, 41) comprend :

   un corps de buse en forme de cuvette (2, 32, 42) monté au fond de la cuve de réaction pour constituer au moins une partie de la partie centrale inférieure de la cuve ;
   une pluralité d'ouvertures de buse (5a, 5b, 5c ; 35a, 35b, 35c ; 45a, 45b, 45c) disposées sur le corps de buse (2, 32, 42) dans des positions situées le long d'une pluralité de zones circulaires (C) qui sont concentriques les unes par rapport aux autres autour de l'axe central dudit fond de la cuve de réaction ;
   un ou plusieurs canaux d'entrée de gaz (4a, 4b, 4c ; 34a, 34b, 34c ; 44a, 44b, 44c) passant par le corps de buse (2, 32, 42) et communiquant avec les ouvertures de buse (5a, 5b, 5c ; 35a, 35b, 35c ; 45a, 45b, 45c) à partir du côté de la surface inférieure de la cuve ; et
   un ou plusieurs tuyaux d'entrée de gaz (15, 25) communiquant avec les un ou plusieurs canaux d'entrée de gaz (5a, 5b, 5c ; 35a, 35b, 35c ; 45a, 45b, 45c) et amenant le gaz mélangé de matériau d'enrobage aux canaux à partir d'un système d'alimentation en gaz disposé à l'extérieur de la cuve de réaction,
l'appareil étant **caractérisé en ce que**
il comprend en outre une pompe d'aspiration (15A) pour décharger le gaz mélange de matériau d'enrobage qui a fui de la cuve de réaction à lit fluidisé vers l'extérieur du boîtier.

3. Appareil selon la revendication 2, dans lequel ledit système d'alimentation en gaz comprend une cuve d'évaporation (162) pour générer un gaz d'enrobage à amener dans la cuve de réaction afin de former une couche d'enrobage de carbure de silicium sur chacune des surfaces des noyaux de combustible dans la cuve de réaction, et des moyens de régulation de température (164) pour réguler par thermostat la température de fonctionnement de la cuve d'évaporation (162).

4. Appareil selon la revendication 2, dans lequel ledit système d'alimentation en gaz comprend une cuve d'évaporation (162) pour générer un gaz mélangé de matériau d'enrobage destiné à être amené dans la cuve de réaction, un tuyau de conduite constituant une conduite d'alimentation en gaz pour amener ledit gaz mélangé de matériau d'enrobage de la cuve d'évaporation (162) à la cuve de réaction à lit fluidisé, et des moyens de maintien de température pour maintenir la température du tuyau de conduite au-dessus d'une température prédéterminée lorsqu'une couche d'enrobage de carbure de silicium est formée sur chacune des surfaces des noyaux de combustible.

FIG. 1a

FIG. 1b

FIG. 2

FIG. 3

FIG. 4a

FIG. 4b

FIG. 5

FIG. 6

FIG. 7

FIG. 8

FIG. 9

FIG. 10a

FIG. 10b

FIG. 11

FIG. 12

FIG. 13

FIG. 14a

141

147

145

148

149

142

143

144

14A

146

FIG. 14b

14B

141

148

149

145

14C

14D

FIG. 15

FIG. 16

FIG. 17

FIG. 18

## REFERENCES CITED IN THE DESCRIPTION

**Patent documents cited in the description**

- JP 5273374 A
- JP 5287285 A
- US 3398718 A